# EUROPEAN PATENT APPLICATION

(11) **EP 4 444 048 A1**
(43) Date of publication of application: **09.10.2024**
(21) Application number: 24705347.3
(22) Date of filing: 08.02.2024
(51) Int. Cl.: H05K 1/02, H05K 1/14, H05K 1/11, H03H 17/02, H04M 1/02

(54) **ELECTRONIC DEVICE COMPRISING FLEXIBLE PRINTED CIRCUIT BOARD**

(30) Priority: 20.02.2023 KR 20230022174; 18.04.2023 KR 20230050605
(71) Applicant: Samsung Electronics Co., Ltd., Suwon-si, Gyeonggi-do 16677 (KR)
(72) Inventor: LEE, Seungyong, Suwon-si, Gyeonggi-do 16677 (KR); KIM, Youngjoon, Suwon-si, Gyeonggi-do 16677 (KR); MIN, Jungsik, Suwon-si, Gyeonggi-do 16677 (KR); LEE, Seonghyeon, Suwon-si, Gyeonggi-do 16677 (KR)
(74) Representative: Gulde & Partner
(86) International application number: PCT/KR2024/001915
(87) International publication number: WO 2024/177323

(57) **Abstract**

An electronic device according to an exemplary embodiment of the disclosure may include a first electrical element and a second electrical element, and a flexible circuit board configured to transmit signals between the first electrical element and the second electrical element and including a first part, a second part, and a third part positioned between the first part and the second part, in which the flexible circuit board includes a first signal line extending from the first part to the second part, a second signal line extending from the first part to the second part, a first filter included in the first part and including a first conductive pattern electrically connected to the first signal line, and a second filter included in the second part and including a second conductive pattern electrically connected to the second signal line, and in which the first filter and the second filter are configured to have designated electromagnetic isolation between the first signal line and the second signal line. Various other embodiments are possible.

## Description

### [Technical Field]

The disclosure relates to an electronic device including a flexible printed circuit board.

### [Background Art]

An electronic device may include a flexible printed circuit board that electrically connects a first component and a second component.

The information described above may be provided as the related art for the purpose of enhancing the understanding of the disclosure. No assertion or determination is made with respect to the applicability of any of the above-mentioned as the prior art related to the disclosure.

### [Disclosure of Invention]

### [Technical Problem]

There may be interference (e.g., electromagnetic interference (EMI)) between signal lines of a flexible printed circuit board when signals are transmitted between first and second components through the flexible printed circuit board.

Embodiments of the disclosure provide an electronic device including a flexible printed circuit board for reducing electromagnetic interference between signal lines of the flexible printed circuit board. Various examples of the disclosure are provided to address or at least mitigate the above-mentioned issue.

Technical problems to be solved by the disclosure are not limited to the above-mentioned technical problems, and other technical problems, which are not mentioned above, may be understood from the following descriptions by those skilled in the art to which the disclosure pertains.

### [Solution to Problem]

According to the exemplary embodiment of the disclosure, the electronic device includes a first electrical element, a second electrical element, and a flexible printed circuit board. The flexible printed circuit board transmits signals between a first electrical element and a second electrical element. The flexible circuit board includes a first part, a second part, and a third part. The third part is positioned between the first part and the second part. The flexible printed circuit board includes a first signal line, a second signal line, a first filter, and a second filter. The first signal line and the second signal line extend from the first part to the second part. The first filter is included in the first part and includes a first conductive pattern electrically connected to the first signal line. The second filter is included in the second part and includes a second conductive pattern electrically connected to the second signal line. The first filter and the second filter are configured to have designated electromagnetic isolation between the first signal line and the second signal line.

According to the exemplary embodiment of the disclosure, the electronic device includes the first electrical element, the second electrical element, and the flexible printed circuit board. The flexible printed circuit board transmits signals between the first electrical element and the second electrical element. The flexible circuit board includes the first part, the second part, and the third part. The third part is positioned between the first part and the second part. The flexible printed circuit board includes the first signal line, the second signal line, a first notch filter, and a second notch filter. The first signal line and the second signal line extend from the first part to the second part. The first notch filter is included in the first part and includes the first conductive pattern electrically connected to the first signal line. The second notch filter is included in the second part and includes the second conductive pattern electrically connected to the second signal line. A first signal in a first frequency band is transmitted through the first signal line. A second signal in a second frequency band different from the first frequency band is transmitted through the second signal line. The first notch filter is configured to block the second signal. The second notch filter is configured to block the first signal.

According to the exemplary embodiment of the disclosure, the flexible printed circuit board includes the rigid first part, the rigid second part, and the flexible third part. The third part is positioned between the first part and the second part. The flexible printed circuit board includes the first signal line, the second signal line, a first connector, a second connector, the first notch filter, and the second notch filter. The first signal line and the second signal line extend from the first part to the second part. The first connector is disposed on the first part and electrically connected to the first signal line and the second signal line. The second connector is disposed on the second part and electrically connected to the first signal line and the second signal line. The first notch filter is included in the first part and includes the first conductive pattern electrically connected to the first signal line. The second notch filter is included in the second part and includes the second conductive pattern electrically connected to the second signal line.

### [Advantageous Effects of Invention]

According to the electronic device including the flexible printed circuit board according to the exemplary embodiments of the disclosure, it is possible to improve signal integrity by reducing electromagnetic interference between the signal lines of the flexible printed circuit board.

Other effects, which may be obtained or expected by various embodiments of the disclosure, will be directly or implicitly disclosed in the detailed description on the embodiments of the disclosure.

### [Brief Description of Drawings]

The above and other aspects, features, and advantages of specific embodiments of the disclosure will become clearer from the following detailed description, which is provided together with the accompanying drawings.
FIG. 1 is a block diagram of an electronic device in a network environment according to an embodiment of the disclosure.
FIG. 2 is a view illustrating the electronic device according to the embodiment of the disclosure.
FIGS. 3 and 4 are exploded perspective views of the electronic device according to the embodiment of the disclosure.
FIG. 5 is a view illustrating a flexible printed circuit board according to the embodiment of the disclosure.
FIG. 6 is a view illustrating a circuit diagram of the flexible printed circuit board according to the embodiment.
FIG. 7 is a view illustrating part 'C' in FIG. 5 of the flexible printed circuit board according to the embodiment of the disclosure.
FIG. 8 is a view illustrating a plurality of pattern layers of the flexible printed circuit board according to the embodiment of the disclosure.
FIG. 9 is a perspective view illustrating a part of the flexible printed circuit board according to the embodiment of the disclosure.
FIG. 10 is a view illustrating part 'D' in FIG. 5 of the flexible printed circuit board according to the embodiment of the disclosure.
FIG. 11 is a view illustrating the plurality of pattern layers of the flexible printed circuit board according to the embodiment of the disclosure.
FIG. 12 is a perspective view illustrating a part of the flexible printed circuit board according to the embodiment of the disclosure.
FIG. 13 is a view illustrating an equivalent circuit diagram of the flexible printed circuit board including first and second filters according to the embodiment of the disclosure, a graph illustrating frequency response characteristics of the first filter, and a graph illustrating frequency response characteristics of the second filter.
FIG. 14 is a view illustrating a part of the flexible printed circuit board according to various embodiments of the disclosure and graphs illustrating frequency response characteristics according to a first conductive pattern.
FIG. 15 is a view illustrating a part of the flexible printed circuit board according to various embodiments of the disclosure and graphs illustrating frequency response characteristics according to the first conductive pattern.
FIG. 16 is a view illustrating a circuit diagram of the flexible printed circuit board according to the embodiment of the disclosure, a circuit diagram of a flexible printed circuit board according to a first comparative example, and a circuit diagram of a flexible printed circuit board according to a second comparative example.
FIG. 17 is a view illustrating graphs related to isolation and an insertion loss of the flexible printed circuit board according to the embodiment of the disclosure.
FIG. 18 is a view illustrating graphs related to isolation and an insertion loss of the flexible printed circuit board according to the first comparative example.

### [Mode for the Invention]

Hereinafter, various exemplary embodiments of the disclosure will be described in more detail with reference to the accompanying drawings.

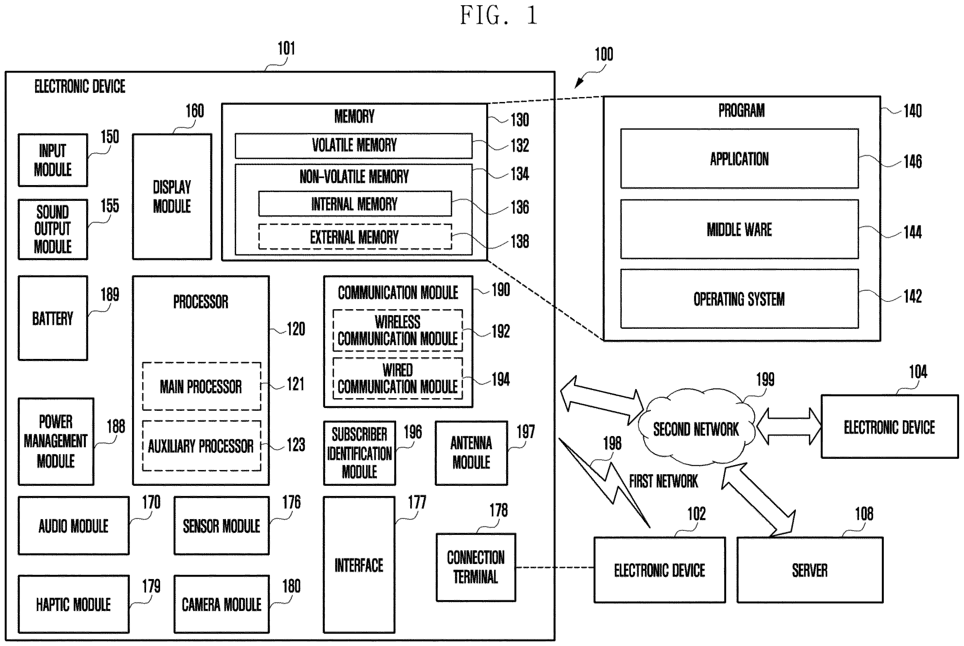

FIG. 1 is a block diagram of an electronic device 101 in a network environment 100 according to an embodiment of the disclosure.

With reference to Fig. 1, the electronic device 101 in the network environment 100 may communicate with an external electronic device 102 via a first network 198 (e.g., a short-range wireless communication network), or at least one of an external electronic device 104 or a server 108 via a second network 199 (e.g., a long-range wireless communication network). The electronic device 101 may communicate with the external electronic device 104 via the server 108. The electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, and/or an antenna module 197. In various embodiments of the disclosure, at least one (e.g., the connection terminal 178) of the components may be omitted from the electronic device 101, or one or more other components may be added in the electronic device 101. In various embodiments of the disclosure, some of the components may be implemented as single integrated circuitry. For example, the sensor module 176, the camera module 180, or the antenna module 197 may be implemented as embedded in single component (e.g., the display module 160).

The processor 120 may execute, for example, software (e.g., a program 140) to control at least one other component (e.g., a hardware or software component) of the electronic device 101 coupled with the processor 120, and may perform various data processing or computation. As at least part of the data processing or computation, the processor 120 may load a command or data received from another component (e.g., the sensor module 176 or the communication module 190) in a volatile memory 132, process the command or the data stored in the volatile memory 132, and store resulting data in a non-volatile memory 134. The processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., a sleep) state, or together with the main processor 121 while the main processor 121 is in an active state (e.g., executing an application). The auxiliary processor 123 (e.g., an ISP or a CP) may be implemented as part of another component (e.g., the camera module 180 or the communication module 190) functionally related to the auxiliary processor 123. According to an embodiment of the disclosure, the auxiliary processor 123 (e.g., a neural network processing device) may include a hardware structure specified for processing an artificial intelligence model. The artificial intelligence model may be created through machine learning. Such learning may be performed, for example, in the electronic device 101 itself on which the artificial intelligence model is performed, or may be performed through a separate server (e.g., the server 108). The learning algorithms may include, for example, supervised learning, unsupervised learning, semi-supervised learning, or reinforcement learning, but is not limited thereto. The artificial intelligence model may include a plurality of artificial neural network layers. The artificial neural network may be any of a deep neural network (DNN), a convolutional neural network (CNN), a recurrent neural network (RNN), a restricted Boltzmann machine (RBM), a deep belief network (DBN), a bidirectional recurrent DNN (BRDNN), a deep Q-network, or a combination of two or more of the above-mentioned networks, but is not limited the above-mentioned examples. In addition to the hardware structure, the artificial intelligence model may additionally or alternatively include a software structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 and/or the non-volatile memory 134.

The program 140 may be stored in the memory 130 as software, and may include, for example, an operating system (OS) 142, middleware 144, and/or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record, and the receiver may be used for incoming calls. The receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. The display module 160 may include touch circuitry (e.g., a touch sensor) adapted to detect a touch, or sensor circuitry (e.g., a pressure sensor) adapted to measure the intensity of force incurred by the touch.

The audio module 170 may convert a sound into an electrical signal and vice versa. The audio module 170 may obtain the sound via the input module 150, or output the sound via the sound output module 155 or a headphone of an external electronic device (e.g., the external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. The interface 177 may include, for example, a high-definition multimedia interface (HDMI), a universal serial bus (USB) interface, a secure digital (SD) card interface, and/or an audio interface.

The connecting terminal 178 may include a connector via which the electronic device 101 may be physically connected with the external electronic device (e.g., the external electronic device 102). The connecting terminal 178 may include, for example, an HDMI connector, a USB connector, an SD card connector, and/or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, ISPs, or flashes.

The power management module 188 may manage power supplied to or consumed by the electronic device 101. The power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more CPs that are operable independently from the processor 120 (e.g., the AP) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BLUETOOTH, wireless-fidelity (Wi-Fi) direct, or IR data association (IrDA)) or the second network 199 (e.g., a long-range communication network, such as a legacy cellular network, a 5th generation (5G) network, a next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4th generation (4G) network, and next-generation communication technology, e.g., new radio (NR) access technology. The NR access technology may support high-speed transmission of high-capacity data (i.e., enhanced mobile broadband (eMBB)), minimization of terminal power and connection of multiple terminals (massive machine type communications (mMTC)), or high reliability and low latency (ultra-reliable and low-latency communications (URLLC)). The wireless communication module 192 may support a high-frequency band (e.g., a mmWave band) to achieve, for example, a high data transmission rate. The wireless communication module 192 may support various technologies for securing performance in a high-frequency band, such as beamforming, massive multiple-input and multiple-output (MIMO), full-dimensional MIMO (FD-MIMO), array antenna, analog beam-forming, or large-scale antenna. The wireless communication module 192 may support various requirements specified in the electronic device 101, an external electronic device (e.g., external the electronic device 104), or a network system (e.g., the second network 199). According to an embodiment of the disclosure, the wireless communication module 192 may support a peak data rate for implementing eMBB (e.g., 20Gbps or more), loss coverage for implementing mMTC (e.g., 164dB or less), or U-plane latency for realizing URLLC (e.g., 0.5ms or less for each of downlink (DL) and uplink (UL) or 1ms or less for round trip).

The antenna module 197 may transmit or receive a signal or power to or from the outside (e.g., the external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., an antenna array). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. Another component (e.g., a radio frequency integrated circuit (RFIC)) other than the radiating element may be additionally formed as part of the antenna module 197.

According to various embodiments of the disclosure, the antenna module 197 may form a mmWave antenna module. According to an embodiment of the disclosure, the mmWave antenna module may include a PCB, an RFIC that is disposed on or adjacent to a first surface (e.g., the bottom surface) of the PCB and is capable of supporting a predetermined high-frequency band (e.g., a mmWave band), and a plurality of antennas (e.g., array antennas) that is disposed on or adjacent to a second surface (e.g., the top surface or the side surface) of the PCB and is capable of transmitting or receiving a signal of the predetermined high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

Commands or data may be transmitted or received between the electronic device 101 and the external electronic device 104 via the server 108 coupled with the second network 199. Each of the external electronic devices 102 or 104 may be a device of a same type as, or a different type, from the electronic device 101. All or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide an ultra-low delay service using, for example, distributed computing or MEC. In another embodiment of the disclosure, the external electronic device 104 may include an Internet of things (IoT) device. The server 108 may be an intelligent server using machine learning and/or neural networks. According to an embodiment of the disclosure, the external electronic device 104 or the server 108 may be included in the second network 199. The electronic device 101 may be applied to an intelligent service (e.g., smart home, smart city, smart car, or health care) based on 5G communication technology or IoT-related technology.

An electronic device according to an embodiment of the disclosure may be one of various types of electronic devices. The electronic devices may include a portable communication device (e.g., a smartphone), a computer device, a portable multimedia device, a portable medical device, a camera, a wearable device, or a home appliance. However, the electronic device is not limited to any of those described above.

Various embodiments of the disclosure and the terms used herein are not intended to limit the technological features set forth herein to particular embodiments and include various changes, equivalents, or replacements for a corresponding embodiment. In connection with the description of the drawings, the same or similar reference numerals may be used for the similar components. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as " 1st" and "2nd," or "first" and "second" may be used to simply distinguish a corresponding component from another, and does not limit the components in other aspect (e.g., importance or order). If an element (e.g., a first element) is referred to, with or without the term "operatively" or "communicatively," as "coupled with," "coupled to," "connected with," or "connected to" another element (e.g., a second element), the element may be coupled with the other element directly (e.g., wiredly), wirelessly, or via a third element.

The term "module" may include a unit implemented in hardware, software, firmware, or a combination thereof and may interchangeably be used with other terms, for example, "logic," "logic block," "part," or "circuitry". A module may be a single integral component, or a minimum unit or part thereof, adapted to perform one or more functions. For example, according to an embodiment of the disclosure, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

A method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PLAYSTORE^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Each component (e.g., a module or a program) of the above-described components may include a single entity or multiple entities. One or more of the above-described components may be omitted, or one or more other components may be added. Alternatively or additionally, a plurality of components (e.g., modules or programs) may be integrated into a single component. In such a case, the integrated component may perform one or more functions of each of the plurality of components in the same or similar manner as they are performed by a corresponding one of the plurality of components before the integration. Operations performed by the module, the program, or another component may be carried out sequentially, in parallel, repeatedly, or heuristically, or one or more of the operations may be executed in a different order or omitted, or one or more other operations may be added.

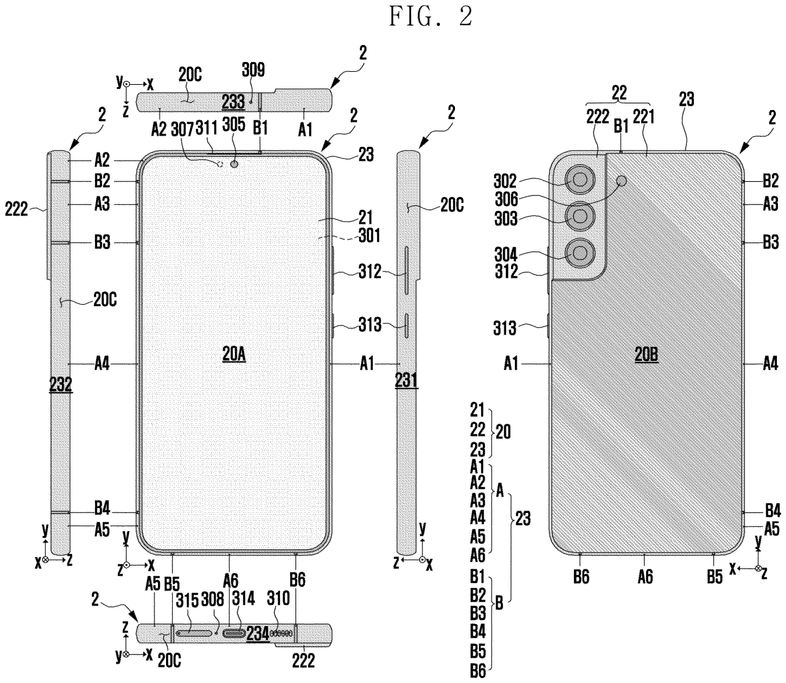

FIG. 2 are views illustrating an electronic device 2 according to an embodiment of the disclosure.

In various embodiments of the disclosure, for convenience of description, a surface in a direction (e.g., a +z-axis direction) in which a display area included in the electronic device 2 is visually viewed is defined as a front surface 20A of the electronic device 2, and a surface in a direction (e.g., a -z-axis direction) opposite to the above-mentioned direction is defined as a rear surface 20B of the electronic device 2.

With reference to FIG. 2, the electronic device 2 may include a housing 20 configured to provide (or define) at least a part of an external appearance of the electronic device 2. For example, the housing 20 may provide the front surface 20A of the electronic device 2, the rear surface 20B of the electronic device 2, and a side surface 20C of the electronic device 2. In various embodiments, the housing 20 may refer to a structure (or construction) that provides at least some of the front surface 20A, the rear surface 20B, and the side surface 20C.

According to the embodiment, the housing 20 may include a front surface plate (or a front surface cover, a first cover, or a first plate) 21, a rear surface plate (or a rear surface cover, a second cover, or a second plate) 22, and/or a side (or a side surface portion, a lateral member, a side surface bezel structure, or a sidewall portion) 23.

According to the embodiment, the front surface plate 21 may provide (or define) at least a part of the front surface 20A of the electronic device 2. At least a part of the front surface plate 21 may be substantially transparent. For example, the front surface plate 21 may include a glass plate or a polymer plate including various coating layers.

According to the embodiment, the rear surface plate 22 may provide (or define) at least a part of the rear surface 20B of the electronic device 2. The rear surface plate 22 may be substantially opaque. For example, the rear surface plate 22 may be made of coated or tinted glass, ceramic, polymer, metal (e.g., aluminum, stainless steel, or magnesium), or a combination of at least two of the above materials.

According to the embodiment, the side 23 may provide (or define) at least a part of the side surface 20C of the electronic device 2. The side 23 may include a metallic material and/or a non-metallic material (e.g., polymer).

According to the embodiment, the side 23 may include a first side (or a first side surface portion, a first sidewall, a first sidewall portion, a first bezel, or a first bezel portion) 231, a second side (or a second side surface portion, a second sidewall, a second sidewall portion, a second bezel, or a second bezel portion) 232, a third side (or a third side surface portion, a third sidewall, a third sidewall portion, a third bezel, or a third bezel portion) 233, and/or a fourth side (or a fourth side surface portion, a fourth sidewall, a fourth sidewall portion, a fourth bezel, or a fourth bezel portion) 234.

According to the embodiment, when viewed from above the front surface plate 21 (e.g., when viewed in the -z-axis direction), the first side 231 may be positioned to be spaced apart from the second side 232 in a first direction (e.g., a +x-axis direction) and substantially parallel to the second side 232. The first side 231 may provide a first side surface of the side surface 20C of the electronic device 2 corresponding to the first direction. The second side 232 may provide a second side surface of the side surface 20C of the electronic device 2 corresponding to a second direction (e.g., a -x-axis direction) opposite to the first direction.

According to the embodiment, the third side 233 may connect one end of the first side 231 and one end of the second side 232. The fourth side 234 may connect the other end of the first side 231 and the other end of the second side 232. When viewed from above the front surface plate 21, the third side 233 may be positioned to be spaced apart from the fourth side 234 in a third direction (e.g., a +y-axis direction) and substantially parallel to the fourth side 234. The third side 233 may provide a third side surface of the side surface 20C of the electronic device 2 corresponding to the third direction. The fourth side 234 may provide a fourth side surface of the side surface 20C of the electronic device 2 corresponding to a fourth direction (e.g., a -y-axis direction) opposite to the third direction.

According to the embodiment, a first corner connected to the first side 231 and the third side 233, a second corner connected to the first side 231 and the fourth side 234, a third corner connected to the second side 232 and the third side 233, and/or a fourth corner connected to the second side 232 and the fourth side 234 may be implemented to have a smoothly curved shape.

According to the embodiment, the side 23 may include an outer metal (or an outer metal structure, an outer conductor, an outer conductive structure, a side surface metal, a side surface metal structure, a side surface conductor, or a side surface conductive structure) A and an outer non-metal (or an outer non-metal structure, an outer non-conductor, an outer non-conductive structure, a side surface non-metal, a side surface non-metal structure, a side surface non-conductor, or a side surface non-conductive structure) B.

According to the embodiment, the outer metal A of the side 23 may include a first outer metal (or a first outer conductive portion or a first side surface conductive portion) A1, a second outer metal (or a second outer conductive portion or a second side surface conductive portion) A2, a third outer metal (or a third outer conductive portion or a third side surface conductive portion) A3, a fourth outer metal (or a fourth outer conductive portion or a fourth side surface conductive portion) A4, a fifth outer metal (or a fifth outer conductive portion or a fifth side surface conductive portion) A5, and/or a sixth outer metal (or a sixth outer conductive portion or a sixth side surface conductive portion) A6.

According to the embodiment, the outer non-metal B of the side 23 may include a first outer non-metal (or a first outer non-conductive portion or a first side surface non-conductive portion) B1, a second outer non-metal (or a second outer non-conductive portion or a second side surface non-conductive portion) B2, a third outer non-metal (or a third outer non-conductive portion or a third side surface non-conductive portion) B3, a fourth outer non-metal (or a fourth outer non-conductive portion or a fourth side surface non-conductive portion) B4, a fifth outer non-metal (or a fifth outer non-conductive portion or a fifth side surface non-conductive portion) B5, and/or a sixth outer non-metal (or a sixth outer non-conductive portion or a sixth side surface non-conductive portion) B6.

According to the embodiment, a combination of the first outer metal A1, the second outer metal A2, the third outer metal A3, the fourth outer metal A4, the fifth outer metal A5, the sixth outer metal A6, the first outer non-metal B 1, the second outer non-metal B2, the third outer non-metal B3, the fourth outer non-metal B4, the fifth outer non-metal B5, and the sixth outer non-metal B6 may provide the first side 231, the second side 232, the third side 233, and the fourth side 234.

According to the embodiment, the first outer non-metal B 1 may be disposed in a first segmentation portion (e.g., a first gap) between the first outer metal A1 and the second outer metal A2. The first outer metal A1 and the second outer metal A2 may be physically separated from each other with the first outer non-metal B 1 interposed therebetween. The first outer non-metal B 1 may be defined or interpreted as a 'first insulation portion'. The second outer non-metal B2 may be disposed in a second segmentation portion (e.g., a second gap) between the second outer metal A2 and the third outer metal A3. The second outer metal A2 and the third outer metal A3 may be physically separated from each other with the second outer non-metal B2 interposed therebetween. The second outer non-metal B2 may be defined or interpreted as a 'second insulation portion'. The third outer non-metal B3 may be disposed in a third segmentation portion (e.g., a third gap) between the third outer metal A3 and the fourth outer metal A4. The third outer metal A3 and the fourth outer metal A4 may be physically separated from each other with the third outer non-metal B3 interposed therebetween. The third outer non-metal B3 may be defined or interpreted as a 'third insulation portion'. The fourth outer non-metal B4 may be disposed in a fourth segmentation portion (e.g., a fourth gap) between the fourth outer metal A4 and the fifth outer metal A5. The fourth outer metal A4 and the fifth outer metal A5 may be physically separated from each other with the fourth outer non-metal B4 interposed therebetween. The fourth outer non-metal B4 may be defined or interpreted as a 'fourth insulation portion'. The fifth outer non-metal B5 may be disposed in a fifth segmentation portion (e.g., a fifth gap) between the fifth outer metal A5 and the sixth outer metal A6. The fifth outer metal A5 and the sixth outer metal A6 may be physically separated from each other with the fifth outer non-metal B5 interposed therebetween. The fifth outer non-metal B5 may be defined or interpreted as a 'fifth insulation portion'. The sixth outer non-metal B6 may be disposed in a sixth segmentation portion (e.g., a sixth gap) between the first outer metal A1 and the sixth outer metal A6. The first outer metal A1 and the sixth outer metal A6 may be physically separated from each other with the sixth outer non-metal B6 interposed therebetween. The sixth outer non-metal B6 may be defined or interpreted as a 'sixth insulation portion'.

According to the embodiment, the side surface 20C of the electronic device 2 may include first surface areas (e.g., conductive surface areas) provided by the first outer metal A1, the second outer metal A2, the third outer metal A3, the fourth outer metal A4, the fifth outer metal A5, and the sixth outer metal A6, and second surface areas (e.g., non-conductive surface areas) provided by the first outer non-metal B1, the second outer non-metal B2, the third outer non-metal B3, the fourth outer non-metal B4, the fifth outer non-metal B5, and the sixth outer non-metal B6. The first surface areas and the second surface areas may be smoothly connected without a substantial height difference.

According to various embodiments, the position, number, or shape of segmentation portions (e.g., gaps) of the outer metal A may be variously implemented without being limited to the illustrated example (not illustrated separately). The shapes of the outer metal A and/or the outer non-metal B may be variously implemented without being limited to the illustrated example (not illustrated separately).

According to the embodiment, the rear surface plate 22 may include a first rear surface plate 221, and a second rear surface plate 222 connected to the first rear surface plate 221. The first rear surface plate 221 may provide one partial surface area of the rear surface 20B of the electronic device 2, and the second rear surface plate 222 may provide the other partial surface area of the rear surface 20B of the electronic device 2.

According to the embodiment, one partial surface area of the rear surface 20B of the electronic device 2, which is provided by the second rear surface plate 222, may be provided to be higher than the other partial surface area of the rear surface 20B of the electronic device 2, which is provided by the first rear surface plate 221, in the direction (e.g., the -z-axis direction) in which the rear surface 20B of the electronic device 2 is directed.

According to the embodiment, a rim of the second rear surface plate 222 may include a first rim corresponding to the first rear surface plate 221 (or connected to the first rear surface plate 221) and a second rim corresponding to the side 23.

According to the embodiment, the second rim of the second rear surface plate 222 corresponding to the side 23 may be provided (or defined) to correspond to the first corner connected to the first side 231 and the third side 233, a portion of the first side 231 extending from the first corner, and a portion of the third side 233 extending from the first corner. The first corner, the portion of the first side 231 extending from the first corner, and the portion of the third side 233 extending from the first corner may be provided to be higher than the other portions of the side 23 while corresponding to a second rim of the second rear surface plate 222 in the direction (e.g., the -z-axis direction) in which the rear surface 20B of the electronic device 2 is directed.

According to the embodiment, the second rear surface plate 222 may be connected to the side 23.

According to the embodiment, it is possible to provide an integrated or single structure (e.g., a single continuous structure or a complete structure) including the outer metal A of the side 23 and the second rear surface plate 222. The second rear surface plate 222 may be connected to the first outer metal A1 and include a metallic material substantially identical to a material of the first outer metal A1.

According to various embodiments, it is possible to implement a configuration in which there is substantially no height difference between one partial surface area of the rear surface 20B of the electronic device 2 provided by the first rear surface plate 221 and the other partial surface area of the rear surface 20B of the electronic device 2 provided by the second rear surface plate 222 (not illustrated separately).

According to various embodiments, it is possible to provide an integrated or single structure (e.g., a single continuous structure or a complete structure) substituted for the first rear surface plate 221 and the second rear surface plate 222.

According to the embodiment, the electronic device 2 may include a display module 301, a first camera module 302, a second camera module 303, a third camera module 304, a fourth camera module 305, a first light-emitting module 306, a second light-emitting module (not illustrated separately), a first sensor module 307, a second sensor module (not illustrated separately), a first sound input module (not illustrated separately), a second sound input module (not illustrated separately), a first sound output module (not illustrated separately), a second sound output module (not illustrated separately), a first key input module 312, a second key input module 313, a first connection terminal 314, and/or a second connection terminal (not illustrated separately). Although not illustrated separately, the electronic device 2 may exclude at least one of the components or may additionally include other components.

According to the embodiment, the display area (or an active area or a screen area) of the display module 301 may be visually viewed through the front surface plate 21.

According to the embodiment, the electronic device 2 may be implemented such that the display area visible through the front surface plate 21 is as large as possible (e.g., a large or full screen). For example, the display module 301 may be provided to have an outer periphery having a shape approximately identical to an outer peripheral shape of the front surface plate 21.

According to the embodiment, the first camera module 302, the second camera module 303, the third camera module 304, and/or the fourth camera module 305 may each include one or more lenses, image sensor (s), and/or image signal processor (ISP).

According to the embodiment, the first camera module 302, the second camera module 303, and the third camera module 304 may be provided to correspond to the rear surface 20B of the electronic device 2. The first camera module 302, the second camera module 303, or the third camera module 304 may be defined or interpreted as a 'rear surface camera module'.

According to the embodiment, the first camera module 302 may be positioned to correspond to a first camera hole provided in the second rear surface plate 222, and the first camera module 302 may be visually viewed from the outside of the electronic device 2 through the first camera hole. The second camera module 303 may be positioned to correspond to a second camera hole provided in the second rear surface plate 222, and the second camera module 303 may be visually viewed from the outside of the electronic device 2 through the second camera hole. The third camera module 304 may be positioned to correspond to a third camera hole provided in the second rear surface plate 222, and the third camera module 304 may be visually viewed from the outside of the electronic device 2 through the third camera hole. In any embodiment, the second rear surface plate 222 may be implemented to provide a first light transmission area substituted for the first camera hole, a second light transmission area substituted for the second camera hole, and/or a third light transmission area substituted for the third camera hole. The second rear surface plate 222 may be referred to as a 'camera deco' or a 'camera deco portion'.

According to the embodiment, when viewed from above the rear surface 20B of the electronic device 2 (e.g., when viewed in the +z-axis direction), the first camera module 302, the second camera module 303, and the third camera module 304 may be disposed in the direction (e.g., the -y-axis direction) from the third side 233 toward the fourth side 234. When viewed from above the rear surface 20B of the electronic device 2, the first camera module 302 may be positioned to correspond to the first corner connected to the first side 231 and the third side 233, and the second camera module 303 may be positioned between the first camera module 302 and the third camera module 304.

According to various embodiments, relative positions between the first camera module 302, the second camera module 303, and the third camera module 304 and the shape of the second rear surface plate 222 corresponding to the relative positions may be variously implemented without being limited to the illustrated example (not illustrated separately). The number of camera modules corresponding to the second rear surface plate 222 may be variously implemented without being limited to the illustrated example (not illustrated separately).

According to various embodiments, the first camera module 302, the second camera module 303, and/or the third camera module 304 may include a wide-angle camera module, a telephoto camera module, a color camera module, a monochrome camera module, or an IR camera module (e.g., a time-of-flight (TOF) camera module or a structured light camera module).

According to the embodiment, the first camera module 302, the second camera module 303, and the third camera module 304 may have different attributes (e.g., view angles) or functions.

According to various embodiments, the first camera module 302, the second camera module 303, and/or the third camera module 304 may provide different view angles (or lenses with different view angles). The electronic device 2 may selectively use the view angle of the first camera module 302, the second camera module 303, and/or the third camera module 304 on the basis of the user's selection related to the view angles.

According to the embodiment, the fourth camera module 305 may be positioned in the electronic device 2 while corresponding to the front surface 20A of the electronic device 2. External light may reach the fourth camera module 305 through the front surface plate 21. The fourth camera module 305 may be defined or interpreted as a 'front surface camera module'.

According to the embodiment, the fourth camera module 305 may be positioned to be closer to the third side 233 than the fourth side 234 when viewed from above the front surface 20A of the electronic device 2 (e.g., when viewed in the -z-axis direction). A distance at which the fourth camera module 305 is spaced apart from the first side 231 and a distance at which the fourth camera module 305 is spaced apart from the second side 232 may be substantially equal to each other when viewed from above the front surface 20A of the electronic device 2.

According to the embodiment, the fourth camera module 305 may be aligned and positioned in an opening provided in the display area of the display module 301, or the fourth camera module 305 may be at least partially inserted into the opening. External light may reach the fourth camera module 305 through the front surface plate 21 and the opening of the display area. The opening of the display area, which is aligned with or overlaps the fourth camera module 305, may be provided in the form of a hole. In various embodiments, when viewed from above the front surface 20A of the electronic device 2, the opening of the display area, which is aligned with or overlaps the fourth camera module 305, may be provided in the form of a notch (not illustrated separately).

According to various embodiments, the fourth camera module 305 may overlap the display area of the display module 301 when viewed from above the front surface 20A of the electronic device 2. The fourth camera module 305 may be positioned on the rear surface of the display area or positioned below (or beneath) the display area. When viewed from the outside of the electronic device 2, the fourth camera module 305 or a position of the fourth camera module 305 may not be substantially visually distinguished (or viewed). For example, the fourth camera module 305 may include a hidden display rear surface camera (e.g., an under-display camera (UDC)). External light may reach the fourth camera module 305 through the front surface plate 21 and the display area.

According to various embodiments, the fourth camera module 305 may be aligned or positioned in a recess (not illustrated separately) provided in the rear surface of the display area, or the fourth camera module 305 may be at least partially inserted into the recess. When viewed from the outside of the electronic device 2, the fourth camera module 305 or a position of the fourth camera module 305 may not be substantially visually viewed (or distinguished).

According to various embodiments, although not illustrated separately, a partial area of the display area of the display module 301, which at least partially overlaps the fourth camera module 305, may include a pixel structure and/or a wiring structure different from those in another area. The pixel structure and/or the wiring structure provided in the partial area of the display area, which at least partially overlaps the fourth camera module 305, may be implemented to reduce a loss of light between the outside of the electronic device 2 and the fourth camera module 305. For example, the partial area of the display area, which at least partially overlaps the fourth camera module 305, may have a pixel density (e.g., the number of pixels per unit area) different from that in another area. For example, the partial area of the display area, which at least partially overlaps the fourth camera module 305, may not substantially include the plurality of pixels.

According to the embodiment, the first light-emitting module 306 may be provided to correspond to the rear surface 20B of the electronic device 2. The first light-emitting module 306 may include a light source for the first camera module 302, the second camera module 303, and/or the third camera module 304. The first light-emitting module 306 may include, but not limited to, an LED, an IR LED, or a xenon lamp.

According to the embodiment, the first light-emitting module 306 may be positioned to corresponding to a flash hole (or a light transmission area) provided in the first rear surface plate 221.

According to various embodiments, the first light-emitting module 306 may be positioned to correspond to a flash hole (or a light transmission area) provided in the second rear surface plate 222 (not illustrated separately).

According to the embodiment, the second light-emitting module (e.g., an LED, an IR LED, or a xenon lamp) (not illustrated separately) may be provided to correspond to the front surface 20A of the electronic device 2. The second light-emitting module may provide state information of the electronic device 2 in the form of light. In various embodiments, the second light-emitting module may provide a light source that operates in conjunction with an operation of the fourth camera module 305.

According to the embodiment, the first sensor module 307 may be positioned in the electronic device 2 while corresponding to the front surface 20A of the electronic device 2. For example, the first sensor module 307 may include an optical sensor (e.g., a proximity sensor or an illuminance sensor). The position of the first sensor module 307 may be variously implemented without being limited to the illustrated example.

According to the embodiment, the first sensor module 307 may overlap the display area of the display module 301 when viewed from above the front surface 20A of the electronic device 2. The first sensor module 307 may be positioned on the rear surface of the display area or positioned below (or beneath) the display area. When viewed from the outside of the electronic device 2, the first sensor module 307 or a position of the first sensor module 307 may not be substantially visually viewed or distinguished. External light may reach the first sensor module 307 through the front surface plate 21 and the display area.

According to various embodiments, the first sensor module 307 may be aligned or positioned in a recess (not illustrated separately) provided in the rear surface of the display area, or the first sensor module 307 may be at least partially inserted into the recess. When viewed from the outside of the electronic device 2, the first sensor module 307 or a position of the first sensor module 307 may not be substantially visually viewed or distinguished.

According to various embodiments, although not illustrated separately, a partial area of the display area of the display module 301, which at least partially overlaps the first sensor module 307, may include a pixel structure and/or a wiring structure different from those in another area. The pixel structure and/or the wiring structure provided in the partial area of the display area, which at least partially overlaps the first sensor module 307, may be implemented to reduce a loss of light between the outside of the electronic device 2 and the first sensor module 307. For example, the partial area in the display area, which at least partially overlaps the first sensor module 307, may have a pixel density (e.g., the number of pixels per unit area) different from that in another area. For example, the partial area of the display area, which at least partially overlaps the first sensor module 307, may not substantially include the plurality of pixels.

According to various embodiments, the first sensor module 307 may be aligned and positioned in an opening provided in the display area of the display module 301, or the first sensor module 307 may be at least partially inserted into the opening. External light may reach the first sensor module 307 through the front surface plate 21 and the opening of the display area. The opening of the display area, which is aligned with or overlaps the first sensor module 307, may be provided in the form of a hole. In various embodiments, when viewed from above the front surface 20A of the electronic device 2, the opening of the display area, which is aligned with or overlaps the first sensor module 307, may be provided in the form of a notch (not illustrated separately).

According to various embodiments, the second sensor module (not illustrated separately) may include an optical, electrostatic, or ultrasonic biosensor (e.g., a fingerprint sensor). The second sensor module may be disposed in the electronic device 2 in a way at least partially identical or similar to that of the first sensor module 307. The electronic device 2 may further include at least one third sensor module (not illustrated separately) provided at various other positions.

According to the embodiment, the first sound input module (not illustrated separately) may include a first microphone (or a first mike). The second sound input module (not illustrated separately) may include a second microphone (or a second mike). For example, the first microphone may be positioned in the electronic device 2 while corresponding to a first microphone hole 308 provided in the fourth side 234. For example, the second microphone may be positioned in the electronic device 2 while corresponding to a second microphone hole 309 provided in the third side 233. The position or number of the microphone and the position or number of the microphone hole 308 or 309 corresponding to the microphone may be variously implemented without being limited to the illustrated example (not illustrated separately).

According to the embodiment, the first sound output module (not illustrated separately) may include a first speaker (not illustrated separately) used to play data related to multimedia or recording. For example, the first speaker may be positioned in the electronic device 2 while corresponding to a first speaker hole 310 provided in the fourth side 234. The position or number of the first sound output module including the first speaker may be variously implemented (not illustrated separately).

According to the embodiment, the second sound output module (not illustrated separately) may include a second speaker (e.g., a telephone receiver) (not illustrated separately) for telephone calls. For example, the second speaker may be positioned in the electronic device 2 while corresponding to a second speaker hole 311 (e.g., an opening in the form of a through-hole or notch) disposed between the front surface plate 21 and the third side 233 and provided in the front surface plate 21 or the third side 233. The position or number of the second sound output module including the second speaker may be variously implemented (not illustrated separately).

According to various embodiments, the first speaker may include a piezoelectric speaker. In this case, the first speaker hole 310 may be excluded.

According to various embodiments, the second speaker may include a piezoelectric speaker. In this case, the second speaker hole 311 may be excluded.

According to various embodiments, it is possible to provide (or define) a first single hole (not illustrated separately) substituted for the first microphone hole 308 and the first speaker hole 310.

According to various embodiments, it is possible to provide (or define) a second single hole (not illustrated separately) substituted for the second microphone hole 309 and the second speaker hole 311.

According to the embodiment, the first key input module 312 and/or the second key input module 313 may include a key positioned in the opening of the first side 231, and a key signal generation part (not illustrated separately) configured to generate a key signal in response to a press or touch on the key. The position or number of the key input module 312 and/or 313 may be variously implemented without being limited to the illustrated example (not illustrated separately).

According to the embodiment, the first connection terminal 314 may be positioned in the electronic device 2 while corresponding to a first connection terminal hole provided in the fourth side 234. An external electronic device may be electrically connected to the electronic device 2 through the first connection terminal 314. The electronic device 2 may receive power and/or data from the external electronic device or transmit power and/or data to the external electronic device through the first connection terminal 314. For example, the first connection terminal 314 may include a USB connector or an HDMI connector. The position or number of the first connection terminal 314 may be variously implemented without being limited to the illustrated example (not illustrated separately).

According to the embodiment, the second connection terminal (not illustrated separately) may be positioned in the electronic device 2 while corresponding to a second connector hole provided in the fourth side 234. A cover member 315 may be positioned in the second connector hole and cover the second connection terminal. An external storage medium, such as a SIM card (or a universal SIM (USIM) card) or a memory card (e.g., a secure digital (SD) memory card), may be connected to the second connector. The position or number of the second connection terminal may be variously implemented without being limited to the illustrated example.

The electronic device 2 may further include various components in accordance with the provided form. All the components cannot be enumerated because the component is variously deformed in accordance with the tendency of convergence of the electronic device 2. However, the electronic device 2 may further additionally include a component equal in level to the above-mentioned components. In various embodiments, particular components may be excluded from the components or substituted with other components in accordance with the provided form. It is to be understood at the present disclosure envisages and includes all combinations of the above-mentioned features and/or embodiments. That is, every combination of the above-described features should be considered as included in the present disclosure as a specific example.

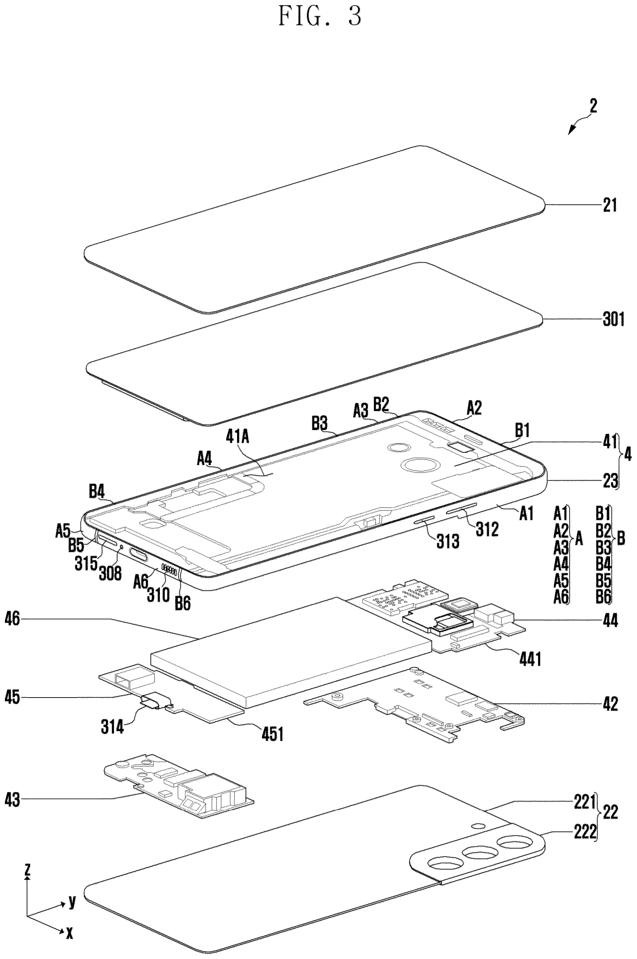

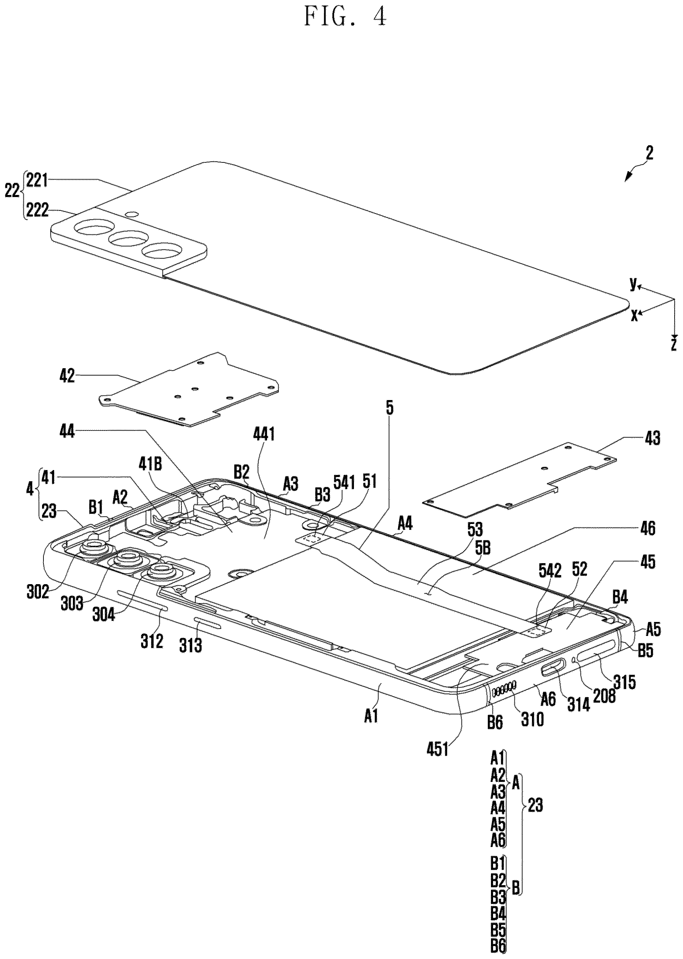

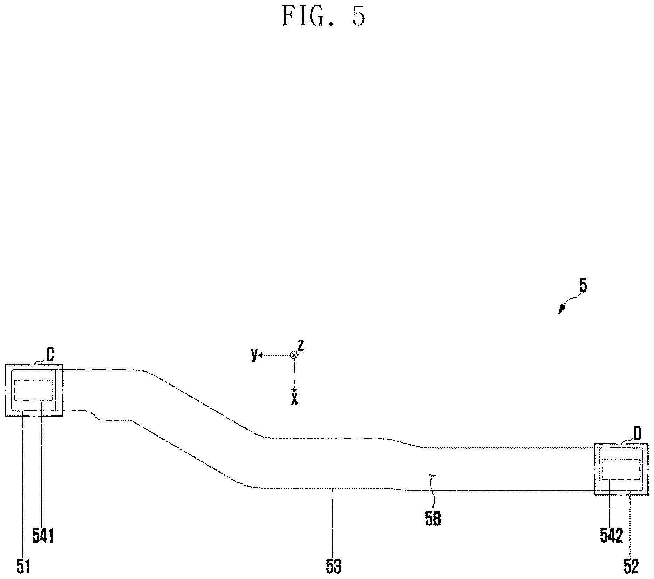

FIGS. 3 and 4 are exploded perspective views of the electronic device 2 according to the embodiment of the disclosure. FIG. 5 is a view illustrating a flexible printed circuit board 5 according to the embodiment of the disclosure. It is to be understood at the present disclosure envisages and includes all combinations of features and/or embodiments disclosed in relation to FIGS. 3, 4, and 5. That is, every combination of the features described below in relation to FIGS. 3, 4, and 5 should be considered as included in the present disclosure as a specific example.

With reference to FIGS. 3, 4, and 5, the electronic device 2 may include the front surface plate 21, the rear surface plate 22, a frame (or a frame structure or a framework) 4, a second support part 42, a third support part 43, the display module 301, a first board assembly 44, a second board assembly 45, a battery 46, and/or the flexible printed circuit board 5. Although not illustrated separately, the electronic device 2 may exclude some the components or may additionally include other components.

According to the embodiment, the frame 4 may include a first support part (or a first support body, a first support member, a first support structure, or a bracket) 41, and the side 23 connected to the first support part 41. The first support part 41 may be at least partially positioned between the front surface plate 21 and the rear surface plate 22. The first support part 41 may include a metallic material and/or a non-metallic material (e.g., polymer). The side 23 may be provided (or defined) as a combination of the outer metal A and the outer non-metal B. A combination (e.g., the frame 4) of the first support part 41 and the side 23 may be interpreted as a structural component for disposing and/or supporting mechanical elements (not illustrated separately) and/or electrical elements (or functional components) such as the display module 301, the first board assembly 44, the second board assembly 45, or the battery 46.

According to various embodiments, the first support part 41 may be interpreted as a part of the housing 20 (see FIG. 2).

According to the embodiment, the first support part 41 may include a first support surface 41A corresponding to the front surface plate 21, and a second support surface 41B corresponding to the rear surface plate 22 and provided opposite to the first support surface 41A.

According to the embodiment, the electronic device 2 may include a first space (not illustrated separately) between the first support surface 41A and the front surface plate 21, and a second space (not illustrated separately) between the second support surface 41B and the rear surface plate 22. One or more components, such as the display module 301, may be disposed on the first support surface 41A or supported by the first support surface 41A in the first space. The plurality of components, such as the first camera module 302, the second camera module 303, the third camera module 304, the second support part 42, the third support part 43, the first board assembly 44, the second board assembly 45, and/or the battery 46, may be disposed on the second support surface 41B or supported by the second support surface 41B in the second space.

According to the embodiment, the first support surface 41A of the first support part 41 may include (or provide) a front surface seating portion for stably disposing or supporting one or more components. The front surface seating portion may be provided as a combination of surface areas having different heights.

According to the embodiment, the second support surface 41B of the first support part 41 may include (or provide) a rear surface seating portion for stably disposing or supporting the plurality of components. The rear surface seating portion may be provided as a combination of surface areas having different heights.

According to the embodiment, the first support part 41 may be provided as a combination of an inner metal (not illustrated separately) and an inner non-metal (not illustrated separately). The inner metal may be provided (or defined) as a combination of one or more conductive portions. The inner non-metal may be provided (or defined) as a combination of one or more non-conductive portions.

According to the embodiment, the first support surface 41A and/or the second support surface 41B of the first support part 41 may be provided (or defined) as a combination of the inner metal (not illustrated separately) and the inner non-metal (not illustrated separately). One partial surface area of the first support surface 41A or the second support surface 41B may include a conductive surface area provided by the inner metal, and the other partial surface area of the first support surface 41A or the second support surface 41B may include a non-conductive surface area provided by the inner non-metal.

According to the embodiment, the inner metal (not illustrated separately) of the first support part 41 may be connected to the outer metal A of the side 23.

According to the embodiment, a first metallic material included in the inner metal (not illustrated separately) of the first support part 41 may be different from a second metallic material included in the outer metal A of the side 23.

According to various embodiments, the first metallic material included in the inner metal (not illustrated separately) of the first support part 41 may be identical to the second metallic material included in the outer metal A of the side 23.

According to the embodiment, it is possible to provide (or define) an integrated or single metal (or a metal structure) (e.g., a single continuous structure or a complete structure) including the inner metal (not illustrated separately) of the first support part 41 and the outer metal A of the side 23. A part of the integrated or single metal may be included in the first support part 41, and another part of the integrated or single metal may be included in the side 23.

According to the embodiment, the inner non-metal (not illustrated separately) of the first support part 41 may be at least partially connected to the outer non-metal B of the side 23.

According to the embodiment, a first non-metallic material included in the inner non-metal (not illustrated separately) of the first support part 41 may be identical to a second non-metallic material included in the outer non-metal B of the side 23.

According to various embodiments, the first non-metallic material included in the inner non-metal (not illustrated separately) of the first support part 41 may be different from the second non-metallic material included in the outer non-metal B of the side 23.

According to the embodiment, it is possible to provide (or define) an integrated or single non-metal (or a non-metal structure) (e.g., a single continuous structure or a complete structure) including the inner non-metal (not illustrated separately) of the first support part 41 and the outer non-metal B of the side 23. A part of the integrated or single non-metal may be included in the first support part 41, and another part of the integrated or single non-metal may be included in the side 23.

According to the embodiment, the display module 301 may be positioned between the first support part 41 and the front surface plate 21. The display module 301 may be disposed on (or coupled to) the front surface plate 21 and/or the first support part 41 (or the first support surface 41A of the first support part 41).

According to the embodiment, the display module 301 may be coupled to the front surface plate 21 by means of an optically transparent adhesive member (or an optically transparent adhesive material) (not illustrated separately) such as an optical clear adhesive (OCA), optical clear resin (OCR), or super view resin (SVR).

According to the embodiment, the first board assembly 44, the second board assembly 45, and/or the battery 46 may be positioned between the first support part 41 and the rear surface plate 22. The first board assembly 44, the second board assembly 45, and/or the battery 46 may be disposed on (or coupled to) the first support part 41 (or the second support surface 41B of the first support part 41).

According to the embodiment, the first board assembly 44 and the second board assembly 45 may be positioned to be spaced apart from each other with the battery 46 interposed therebetween when viewed from above the rear surface plate 22 (e.g., when viewed in the +z-axis direction).

According to the embodiment, when viewed from above the rear surface plate 22, the first board assembly 44 may be at least partially positioned between the third side 233 (see FIG. 2) and the battery 46. When viewed from above the rear surface plate 22, the second board assembly 45 may be at least partially positioned between the fourth side 234 (see FIG. 2) and the battery 46.

According to the embodiment, the first board assembly 44 may include a first printed circuit board 441, electrical elements (not illustrated separately) disposed on the first printed circuit board 441 or connected to the first printed circuit board 441, and/or structural elements (or mechanical elements) (not illustrated separately) disposed on the first printed circuit board 441 or connected to the first printed circuit board 441.

According to the embodiment, the display module 301, the second microphone (not illustrated separately) corresponding to the second microphone hole 309 (see FIG. 2), the first camera module 302, the second camera module 303, the third camera module 304, the fourth camera module 305, the first light-emitting module 306 (see FIG. 2), the first sensor module 307 (see FIG. 2), the first key input module 312, the second key input module 313, or various other electrical elements may be electrically connected to the first printed circuit board 441 of the first board assembly 44 through an electrical path such as the flexible printed circuit board.

According to the embodiment, the second board assembly 45 may include a second printed circuit board 451, electrical elements (not illustrated separately) disposed on the second printed circuit board 451 or connected to the second printed circuit board 451, and/or structural elements (or mechanical elements) (not illustrated separately) disposed on the second printed circuit board 451 or connected to the second printed circuit board 451.

According to the embodiment, the first microphone (not illustrated separately) corresponding to the first microphone hole 308, the first speaker (not illustrated separately) corresponding to the first speaker hole 310, the first connection terminal 314, the second connection terminal (not illustrated separately) corresponding to the cover member 315, or various other electronic components may be electrically connected to the second printed circuit board 451 of the second board assembly 45 through an electrical path such as the flexible printed circuit board.

According to various embodiments, although not illustrated separately, the first printed circuit board 441 of the first board assembly 44 may include a protruding portion (not illustrated separately) extending between the first side 231 (see FIG. 2) and the battery 46 or extending between the second side 232 (see FIG. 2) and the battery 46 when viewed from above the rear surface plate 22. The protruding portion may be electrically connected to the second printed circuit board 451 of the second board assembly 45 through the electrical path such as the flexible printed circuit board.

According to various embodiments, it is possible to provide an integrated or single printed circuit board (not illustrated separately) substituted for the first printed circuit board 441 of the first board assembly 44 and the second printed circuit board 451 of the second board assembly 45. For example, when viewed from above the rear surface plate 22, the integrated or single printed circuit board may include a first board part positioned between the third side 233 (see FIG. 2) and the battery 46, a second board part positioned between the fourth side 234 (see FIG. 2) and the battery 46, and a third board part configured to connect the first board part and the second board part. When viewed from above the rear surface plate 22, the third board part may be positioned between the first side 231 (see FIG. 2) and the battery 46 or positioned between the second side 232 (see FIG. 2) and the battery 46. The third part may be implemented to be substantially rigid or flexible.

According to various embodiments, although not illustrated separately, the first board assembly 44 or the second board assembly 45 may include a primary printed circuit board (or a main printed circuit board), a secondary printed circuit board (or a sub-printed circuit board), and/or an interposer substrate. When viewed from above the rear surface plate 22, the primary printed circuit board and the secondary printed circuit board may at least partially overlap each other. The interposer substrate may be disposed between the primary printed circuit board and the secondary printed circuit board and electrically connect the primary printed circuit board and the secondary printed circuit board.

According to the embodiment, the battery 46 is a device for powering at least one constituent element of the electronic device 2 and may include, for example, a non-rechargeable primary cell, a rechargeable secondary cell, or a fuel cell.

According to the embodiment, the outer metal A of the side 23 may be electrically connected to a first ground structure (not illustrated separately), which is included in the first board assembly 44, through a flexible conductor (or a flexible conductive portion or a flexible conductive member) (not illustrated separately) positioned between the outer metal A and the first board assembly 44. For example, the flexible conductor may include a conductive clip (e.g., a conductive structure including an elastic structure), a pogo-pin, a spring, conductive Poron, a conductive sponge, a conductive rubber, a conductive tape, or a conductive connector.

According to the embodiment, the first ground structure (not illustrated separately) of the first board assembly 44 may include a first ground area (e.g., a first ground plane) included in the first printed circuit board 441, and/or at least one conductor or metal body electrically connected to the first ground area.

According to the embodiment, the outer metal A of the side 23 may be electrically connected to a second ground structure (not illustrated separately), which is included in the second board assembly 45, through a flexible conductor (or a flexible conductive portion or a flexible conductive member) (not illustrated separately) positioned between the outer metal A and the second board assembly 45.

According to the embodiment, the second ground structure (not illustrated separately) of the second board assembly 45 may include a second ground area (e.g., a second ground plane) included in the second printed circuit board 451 and/or at least one conductor or metal body electrically connected to the second ground area.

According to the embodiment, the inner metal (not illustrated separately) of the first support part 41 may be electrically connected to the first ground structure (not illustrated separately), which is included in the first board assembly 44, through a flexible conductor (or a flexible conductive portion or a flexible conductive member) (not illustrated separately) positioned between the inner metal and the first board assembly 44.

According to the embodiment, the inner metal (not illustrated separately) of the first support part 41 may be electrically connected to the second ground structure (not illustrated separately), which is included in the second board assembly 45, through a flexible conductor (or a flexible conductive portion or a flexible conductive member) (not illustrated separately) positioned between the inner metal and the second board assembly 45.

According to the embodiment, the first ground structure (not illustrated separately) of the first board assembly 44 and the second ground structure (not illustrated separately) of the second board assembly 45 may be electrically connected by an electrical connection member (e.g., the flexible printed circuit board 5) that electrically connects the first printed circuit board 441 and the second printed circuit board 451.

According to the embodiment, a combination of the outer metal A of the side 23 and the inner metal (not illustrated separately) of the first support part 41 may be defined or interpreted as a 'third ground structure' of the frame 4.

According to the embodiment, the display module 301 may be electrically connected to the inner metal of the first support part 41 through a conductive member (not illustrated separately) positioned between the display module 301 and the inner metal (not illustrated separately) of the first support part 41. For example, at least one conductive layer (e.g., an electromagnetic blocking metal sheet such as a copper sheet) (not illustrated separately) included in the display module 301 may be electrically connected to the inner metal through a conductive member (not illustrated separately) positioned between at least one conductive layer and the inner metal of the first support part 41. For example, the conductive member may include a conductive adhesive material (or a conductive bonding material). For example, the conductive member may include a flexible conductor (or a flexible conductive portion or a flexible conductive member).

According to the embodiment, at least one conductive layer (e.g., an electromagnetic blocking metal sheet such as a copper sheet) (not illustrated separately), which is electrically connected to the inner metal (not illustrated separately) of the first support part 41 of the display module 301, may be defined or interpreted as a 'fourth ground structure' .

According to the embodiment, a combination of the first ground structure of the first board assembly 44, the second ground structure of the second board assembly 45, the third ground structure of the frame 4, and/or the fourth ground structure of the display module 301 may be defined or interpreted as a 'ground structure (or ground)' of the electronic device 2. The ground structure of the electronic device 2 may further include various other ground structures (e.g., a conductor or a metal body) (not illustrated separately) electrically connected to the first ground structure of the first board assembly 44, the second ground structure of the second board assembly 45, the third ground structure of the frame 4, and/or the fourth ground structure of the display module 301.

According to the embodiment, the ground structure of the electronic device 2 may reduce or prevent electromagnetic interference (EMI) to the electrical elements included in the electronic device 2. The ground structure of the electronic device 2 may reduce or prevent an electromagnetic effect applied to the electrical elements, which are included in the electronic device 2, by noise from the outside of the electronic device 2. The ground structure of the electronic device 2 may reduce or prevent electromagnetic interference between the electrical elements included in the electronic device 2.

The electronic device 2 may include a first conductive area (not illustrated separately) and a second conductive area (not illustrated separately). The first and second conductive areas may be electrically connected or electrically and physically connected. According to various embodiments of the disclosure, in case that the first conductive area is configured to substantially radiate electromagnetic waves, the first conductive area of the combination of the first conductive area and the second conductive area may be defined or interpreted as an antenna radiator, and the second conductive area of the combination of the first conductive area and the second conductive area may be defined or interpreted as the ground structure of the electronic device 2 that is distinguished from the antenna radiator. According to various embodiments of the disclosure, in case that the first conductive area is configured to substantially radiate electromagnetic waves, the combination of the first conductive area and the second conductive area may be defined or interpreted as the ground structure of the electronic device 2, and the first conductive area may be defined or interpreted as the antenna radiator implemented by a part of the ground structure of the electronic device 2. According to various embodiments of the disclosure, in case that the first conductive area is configured to substantially radiate electromagnetic waves, the second conductive area may be configured as an antenna ground that applies an electromagnetic effect to the first conductive area (e.g., the antenna radiator). The antenna ground may contribute to ensuring antenna radiation performance (or radio wave transmitting/receiving performance or communication performance) and/or ensuring coverage related to the antenna radiator. The antenna ground may reduce electromagnetic interference (EMI) or a signal loss related to the antenna radiator.

According to the embodiment, some (not illustrated separately) of the ground structures of the electronic device 2 may be configured as the antenna radiator. Some of the ground structures of the electronic device 2 may be electrically connected to a wireless communication circuit (or a wireless communication module) (not illustrated separately) included in the first board assembly 44 or the second board assembly 45. Some of the ground structures of the electronic device 2 may receive (or be supplied with) an electromagnetic signal (or a radio signal, an RF signal, or a radiation current) from the wireless communication circuit and operate as the antenna radiator (or a radiator, a radiation part, or a resonator). For example, some of the ground structures of the electronic device 2, which are configured as the antenna radiator, may include at least a part of the outer metal A included in the side 23. For example, some of the ground structures of the electronic device 2, which are configured as the antenna radiator, may include at least a part of the conductive layer (e.g., the electromagnetic blocking metal sheet such as a copper sheet) (not illustrated separately) included in the display module 301. Some of the ground structures of the electronic device 2, which are configured as the antenna radiator, may be variously implemented (not illustrated separately).

According to the embodiment, in case that at least a part of the outer metal A included in the side 23 is configured to radiate electromagnetic waves, at least a part of the outer metal A included in the side 23 may be defined or interpreted as being excluded from the third ground structure of the frame 4 or the ground structure of the electronic device 2. Various other conductive portions (or conductive areas or conductive patterns), which are configured to radiate electromagnetic waves, may be defined or interpreted as being excluded from the ground structure of the electronic device 2.

According to the embodiment, some (not illustrated separately) of the ground structures of the electronic device 2 may be configured as the antenna ground that applies the electromagnetic effect to at least one antenna radiator.

According to the embodiment, the wireless communication circuit (e.g., the wireless communication module 192 in FIG. 1) of the electronic device 2 may process a transmission signal or a reception signal in at least one selected or designated frequency band by means of at least one antenna radiator. The selected or designated frequency band may include at least one of, for example, a low band (LB) (about 600 MHz to about 1 GHz), a middle band (MB) (about 1 GHz to about 2.3 GHz), a high band (HB) (about 2.3 GHz to about 2.7 GHz), or an ultra-high band (UHB) (about 2.7 GHz to about 6 GHz). The designated frequency band may include various other frequency bands.

According to the embodiment, the second support part (or a second support body, a second support member, or a second support structure) 42 may be positioned between the first support part 41 and the rear surface plate 22. At least a part of the first board assembly 44 may be positioned between the first support part 41 and the second support part 42. The second support part 42 may cover and/or protect the first board assembly 44. The second support part 42 may be coupled to the first support part 41 and/or the first board assembly 44 by means of screw fastening or various other mechanical fastening methods.

According to the embodiment, the third support part (or a third support body, a third support member, or a third support structure) 43 may be positioned between the first support part 41 and the rear surface plate 22. At least a part of the second board assembly 45 may be positioned between the first support part 41 and the third support part 43. The third support part 43 may cover and/or protect the second board assembly 45. The third support part 43 may be coupled to the first support part 41 and/or the second board assembly 45 by screw fastening or various other mechanical fastening methods.

According to the embodiment, when viewed from above the rear surface plate 22, the third support part 43 may be positioned to be at least partially spaced apart from the second support part 42 with the battery 46 interposed therebetween.

According to various embodiments, the second support part 42 and/or the third support part 43 may be interpreted as a part of the housing 20 (see FIG. 2).

According to the embodiment, the frame 4 may be defined or interpreted as a 'front case' of the electronic device 2, and the second support part 42 and/or the third support part 43 may be defined or interpreted as a 'rear case' of the electronic device 2.

According to various embodiments, it is possible to provide an integrated or single support part (e.g., a single continuous structure or a complete structure) (not illustrated separately) substituted for the second support part 42 and the third support part 43.

According to the embodiment, the second support part 42 and/or the third support part 43 may include a metallic material and/or a non-metallic material (e.g., polymer).

According to the embodiment, the second support part 42 or the third support part 43 may include at least one antenna radiator (not illustrated separately) configured to radiate electromagnetic waves. For example, the second support part 42 or the third support part 43 may include a non-conductor (not illustrated separately) made of a non-metallic material, and at least one conductive pattern (not illustrated separately) disposed on the non-conductor. For example, at least one conductive pattern may be disposed on the non-conductor by laser direct structuring (LDS). The LDS may refer to a method of forming the conductive pattern by designing a pattern on the non-conductor by using a laser and plating an upper portion of the pattern with an electrically conductive material such as copper or nickel. At least one conductive pattern, which is included in the second support part 42 or the third support part 43, may receive (or be supplied with) an electromagnetic signal (or a radio signal, an RF signal, or a radiation current) from the wireless communication circuit (e.g., wireless communication module) included in the first board assembly 44 or the second board assembly 45 and operate as the antenna radiator (or a radiator, a radiation part, or a resonator).

According to the embodiment, the flexible printed circuit board 5 may electrically connect the first printed circuit board 441 of the first board assembly 44 and the second printed circuit board 451 of the second board assembly 45.

According to the embodiment, the flexible printed circuit board 5 may include the ground structure for reducing the electromagnetic interference (EMI) related to a plurality of signal lines (or electrical paths) and a plurality of signal lines (electrical paths).

According to the embodiment, the flexible printed circuit board 5 may include a plurality of pattern layers (not illustrated separately) including conductive patterns, a plurality of non-conductive layers (e.g., insulating layers) (not illustrated separately) disposed between the plurality of pattern layers, and a plurality of conductive vias (not illustrated separately). The conductive via may be a conductive hole provided to dispose a conductive connection wire for electrically connecting conductive patterns of different pattern layers of the flexible printed circuit board 5. Examples of the conductive via may include a plated through hole (PTH), a laser via hole (LVH), a buried via hole (BVH), or a stacked via. For example, one or more conductive vias may be some of signal lines and electrically connect signal line patterns included in different pattern layers of the flexible printed circuit board 5 (e.g., conductive patterns (lines) used as electrical paths). For example, one or more conductive vias may electrically connect ground planes (or ground areas or ground patterns) included in different pattern layers of the flexible printed circuit board 5. The number of pattern layers and non-conductive layers included in the flexible printed circuit board may be variously implemented.

According to the embodiment, a combination (e.g., a conductive structure) of the ground planes of the different pattern layers of the flexible printed circuit board 5 and one or more conductive vias, which electrically connect the ground planes (or ground areas or ground patterns) of the different pattern layers, may define a ground structure (not illustrated separately) of the flexible printed circuit board 5. The ground structure of the flexible printed circuit board 5 may reduce electromagnetic interference (EMI) or crosstalk between the plurality of signal lines included in the flexible printed circuit board 5. The ground structure of the flexible printed circuit board 5 may reduce or block the electromagnetic effect (e.g., electromagnetic interference) applied to the plurality of signal lines of the flexible printed circuit board 5 by noise from the outside of the flexible printed circuit board 5.

According to the embodiment, the flexible printed circuit board 5 may be provided in the form of a film having a thickness between a first surface (not illustrated separately) and a second surface 5B directed in a direction opposite to the first surface. The first surface may be directed toward the front surface plate 21, and the second surface 5B may be directed toward the rear surface plate 22.

According to the embodiment, the flexible printed circuit board 5 may traverse the battery 46 when viewed from above the rear surface plate 22.

According to the embodiment, the flexible printed circuit board 5 may include a first part 51, a second part 52, a third part 53, a first connector 541, and/or a second connector 542.

According to the embodiment, the third part 53 may be provided between the first part 51 and the second part 52 and connect the first part 51 and the second part 52. The first part 51 and the second part 52 may extend from the third part 53 with the third part 53 interposed therebetween.

According to the embodiment, when viewed from above the rear surface plate 22, the first part 51 of the flexible printed circuit board 5 may at least partially overlap the first printed circuit board 441. When viewed from above the rear surface plate 22, the second part 52 of the flexible printed circuit board 5 may at least partially overlap the second printed circuit board 451. When viewed from above the rear surface plate 22, the third part 53 of the flexible printed circuit board 5 may at least partially overlap the battery 46.

According to the embodiment, the first connector 541 may be disposed on the first part 51, and the second connector 542 may be disposed on the second part 52. The first connector 541 and the second connector 542 may be disposed on the first surface of the flexible printed circuit board 5 by means of a conductive adhesive material (or a bonding material) (not illustrated separately) such as solder, copper, silver paste, aluminum, silver-aluminum, carbon paste, or carbon nanotube (CNT) paste.

According to the embodiment, the first connector 541 may be electrically connected to the first printed circuit board 441. The second connector 542 may be electrically connected to the second printed circuit board 451. The first connector 541 may be a first board-to-board (BTB) connector, and the second connector 542 may be a second BTB connector.

According to the embodiment, the first connector 541 and the second connector 542 may be disposed on the first surface (not illustrated separately) of the flexible printed circuit board 5 directed toward the front surface plate 21. The first connector 541 (e.g., the first BTB connector) and a third connector (e.g., a third BTB connector) (not illustrated separately), which is provided on the first printed circuit board 441 and electrically connected to the first connector 541, may be positioned between the first part 51 and the first printed circuit board 441. The second connector 542 (e.g., the second BTB connector) and a fourth connector (e.g., a fourth BTB connector) (not illustrated separately), which is provided on the second printed circuit board 451 and electrically connected to the second connector 541, may be positioned between the second part 52 and the second printed circuit board 451.

According to various embodiments, the first part 51 may be implemented as a first terminal part (not illustrated separately) substituted for the first connector 541 and including a plurality of terminals (or a plurality of pins). The first terminal part may be implemented to be substantially rigid and flat. The first terminal part may include a reinforcement plate (or a reinforcement film) (e.g., a stiffener) and be substantially rigid and flat. For example, the reinforcement plate may include FR4 (e.g., glass-reinforced epoxy laminate material) or polyimide (PI). A connector (or a receptacle) (e.g., a flat flexible cable (FFC) connector or a flexible printed circuit (FPC) connector) capable of connecting the first terminal part of the flexible printed circuit board 5 may be disposed on the first printed circuit board 441.

According to various embodiments, the second part 52 may be implemented as a second terminal part (not illustrated separately) substituted for the second connector 542 and including a plurality of terminals (or a plurality of pins). The second terminal part may be implemented to be substantially rigid and flat. The second terminal part may include a reinforcement plate (or a reinforcement film) (e.g., a stiffener) and be substantially rigid and flat. For example, the reinforcement plate may include FR4 or PI. A connector (or a receptacle) (e.g., an FFC connector or an FPC connector) capable of connecting the second terminal part of the flexible printed circuit board 5 may be disposed on the second printed circuit board 451.

According to the embodiment, the third part 53 may be flexible, and the first part 51 and/or the second part 52 may be less flexible than the third part 53 or more rigid than the third part 53.

According to the embodiment, the third part 53 may be disposed to be curved in a shape corresponding to a combination of surfaces of the components that face the first surface of the flexible printed circuit board 5.

According to the embodiment, the first part 51 and/or the second part 52 may have a larger thickness or a larger number of stacked layers than the third part 53 and then be more rigid than the third part 53.

According to various embodiments, the first part 51 and/or the second part 52 may include a material different from the material of the third part 53 so that the first part 51 and/or the second part 52 is more rigid than the third part 53.

According to the embodiment, the first part 51 may include a first reinforcement plate (or a first reinforcement film) (e.g., a first stiffener) (not illustrated separately) and thus be less flexible than the third part 53. The second part 52 may include a second reinforcement plate (or a second reinforcement film) (e.g., a second stiffener) (not illustrated separately) and thus be less flexible than the third part 53. For example, the first reinforcement plate and/or the second reinforcement plate may include FR4 or PI.

According to various embodiments, the first part 51 may be referred to as a 'first rigid portion,' a 'first rigid area,' or a 'first rigid section' of the flexible printed circuit board 5. The second part 52 may be referred to as a 'second rigid portion,' a 'second rigid area,' or a 'second rigid section' of the flexible printed circuit board 5. The third part 53 may be referred to as a 'flexible portion,' a 'flexible area,' or a 'flexible section' of the flexible printed circuit board 5.

According to various embodiments, the flexible circuit board 5 may be implemented as a rigid flexible printed circuit board.

According to the embodiment, the flexible printed circuit board 5 may be used as a transmission line in an antenna device (or an antenna system) including at least one antenna radiator (not illustrated separately), the wireless communication circuit (e.g., the wireless communication module 192 in FIG. 1), and/or the antenna ground (not illustrated separately). The flexible printed circuit board 5 may transmit an electromagnetic signal (or a radio signal, an RF signal, or a radiation current).

According to the embodiment, the flexible printed circuit board 5 may be an FRC (a flexible RF cable or a flexible PCB type RF cable).

According to the embodiment, the second board assembly 45 or the second printed circuit board 451 may include the antenna radiator or be electrically connected to the antenna radiator. The wireless communication circuit (e.g., the wireless communication module 192 in FIG. 1) may be disposed on the first printed circuit board 441. The wireless communication circuit may be electrically connected to the antenna radiator through the flexible printed circuit board 5. The wireless communication circuit may provide (or supply) the electromagnetic signal (or the radio signal, the RF signal, or the radiation current) to the antenna radiator through the flexible printed circuit board 5, and the antenna radiator may radiate electromagnetic waves. The wireless communication circuit may be configured to transmit a signal in at least one selected or designated frequency band to the outside of the electronic device 2 through the antenna radiator. The wireless communication circuit may be configured to receive a signal in at least one selected or designated frequency band from the outside of the electronic device 2 through the antenna radiator.

According to the embodiment, at least a part of the sixth outer metal A6 may be configured to operate as the antenna radiator that radiates electromagnetic waves. The electronic device 2 may include a first flexible conductor (or a first flexible conductive portion or a first flexible conductive member) (not illustrated separately) and/or a second flexible conductor (or a second flexible conductive portion or a second flexible conductive member) (not illustrated separately) disposed on the second printed circuit board 451. The first flexible conductor and the second flexible conductor may be elastically in contact with the sixth outer metal A6. The sixth outer metal A6 may be electrically connected to the second printed circuit board 451 through the first flexible conductor and the second flexible conductor. The first flexible conductor and/or the second flexible conductor may be a conductive clip (e.g., a conductive structure including an elastic structure. However, the disclosure is not limited thereto, and the first flexible conductor and/or the second flexible conductor may be variously configured as a pogo-pin, a spring, conductive Poron, conductive rubber, a conductive tape, or a conductive connector. The sixth outer metal A6 may be electrically connected to the wireless communication circuit (e.g., the wireless communication module 192 in FIG. 1) disposed on the first printed circuit board 441 through the flexible printed circuit board 5. The sixth outer metal A6 may be electrically connected to the second ground area of the second printed circuit board 451 through the second flexible conductor. A position on or a portion of the sixth outer metal A6, which is electrically connected to the first flexible conductor, may be defined or interpreted as a 'feeding point'. A position on or a portion of the sixth outer metal A6, which is electrically connected to the second flexible conductor, may be defined or interpreted as a 'grounding point'. When the wireless communication circuit disposed on the first printed circuit board 441 provides (or supply) the electromagnetic signal (or the radio signal, the RF signal, or the radiation current) to the feeding point of the sixth outer metal A6 through the flexible printed circuit board 5, a signal path may be defined between the grounding point and the feeding point of the sixth outer metal A6. At least a part of the sixth outer metal A6 may define an electrical length (an electrical path) (e.g., a length represented by a ratio between wavelengths) corresponding to the signal path and operate as the antenna radiator having a resonant frequency corresponding to the electrical length. In various embodiments, the first outer metal A1 or the fifth outer metal A5 may be configured to operate as the antenna radiator in a substantially identical or similar way.

According to the embodiment, the electronic device 2 including the flexible printed circuit board 5 has an external shape of a bar type or plate type electronic device. However, the electronic device 2 is not limited thereto. For example, the electronic device 2 including the flexible printed circuit board 5 may be implemented as various other types such as a foldable electronic device, a slidable electronic device, a stretchable electronic device, or a rollable electronic device.

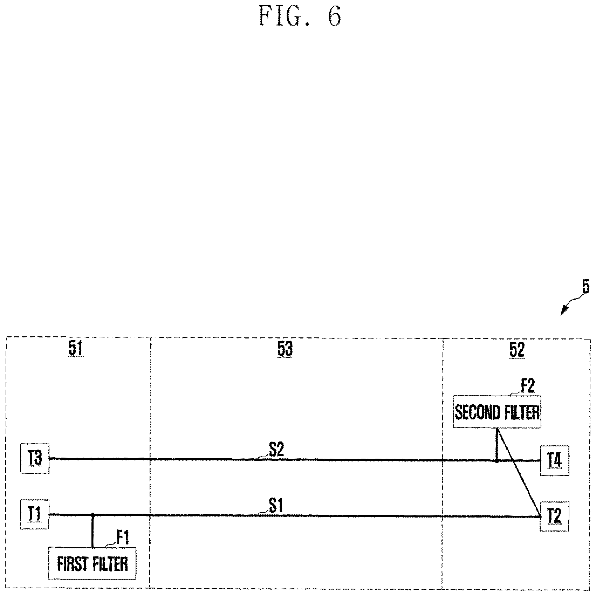

FIG. 6 is a view illustrating a circuit diagram of the flexible printed circuit board 5 according to the embodiment. It is to be understood at the present disclosure envisages and includes all combinations of features and/or embodiments disclosed in relation to FIG. 6. That is, every combination of the features described below in relation to FIG. 6 should be considered as included in the present disclosure as a specific example.

With reference to FIG. 6, the flexible printed circuit board 6 may include a first signal line S1, a second signal line S2, a first terminal T1, a second terminal T2, a third terminal T3, a fourth terminal T4, a first filter F1, and/or a second filter F2.

According to the embodiment, the first signal line S1 and the second signal line S2 extend from the first part 51 to the second part 52 of the flexible printed circuit board 5. The first signal line S1 and the second signal line S2 may be physically separated.

According to the embodiment, the first signal line S1 may include the first terminal T1 (e.g., a first conductive pad) included in the first part 51, and the second terminal T2 (e.g., a second conductive pad) included in the second part 52. The second signal line S2 may include the third terminal T3 included in the first part 51, and the fourth terminal T4 included in the second part 52. The first terminal T1 and the third terminal T3 may be physically and electrically connected to the first connector 541 (see FIG. 5) by means of a conductive adhesive material (or a bonding material) (not illustrated separately) such as solder, copper, silver paste, aluminum, silver-aluminum, carbon paste, or CNT paste. The second terminal T2 and the fourth terminal T4 may be physically and electrically connected to the second connector 542 (see FIG. 5) by means of a conductive adhesive material (or a bonding material) (not illustrated separately).

According to the embodiment, although not illustrated separately, the first signal line S1 may include a combination of first signal line patterns, which are included in different pattern layers of the flexible printed circuit board 5, and at least one conductive via configured to electrically connect the first signal line patterns.

According to the embodiment, although not illustrated separately, the second signal line S2 may include a combination of second signal line patterns, which are included in different pattern layers of the flexible printed circuit board 5, and at least one conductive via configured to electrically connect the second signal line patterns.

According to the embodiment, the first filter F1 is included in the first part 51. The first filter F1 is electrically connected to the first signal line S1.

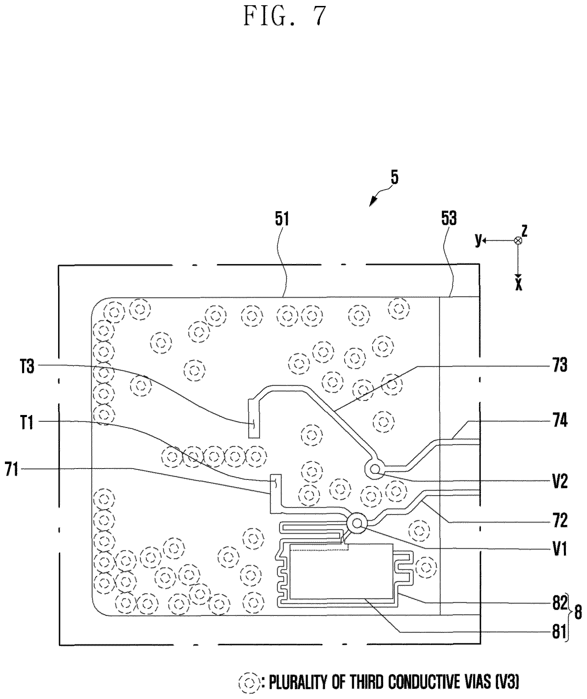

According to the embodiment, the first filter F1 includes a first conductive pattern electrically connected to the first signal line S1. The first conductive pattern may be configured to apply an element value such as capacitance, inductance, and/or conductance between the first signal line S1 and the second signal line S2. For example, the first conductive pattern may include a combination of a plurality of partially conductive patterns, which is included in different pattern layers of the flexible printed circuit board 5, and at least one conductive via configured to electrically connect the plurality of partially conductive patterns. The first conductive pattern according to the exemplary embodiment will be described with reference to FIGS. 7, 8, and 9.

According to the embodiment, the second filter F2 is included in the second part 52. The second filter F2 is electrically connected to the second signal line S2.

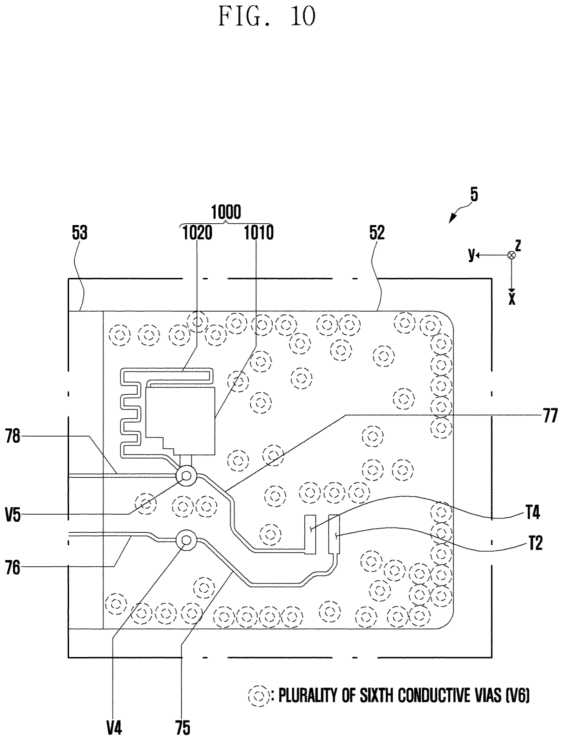

According to the embodiment, the second filter F2 includes a second conductive pattern electrically connected to the second signal line S2. The second conductive pattern may be configured to apply an element component such as capacitance, inductance, and/or conductance between the first signal line S1 and the second signal line S2. For example, the second conductive pattern of the second filter F2 may include a combination of a plurality of partially conductive patterns, which is included in different pattern layers of the flexible printed circuit board 5, and at least one conductive via configured to electrically connect the plurality of partially conductive patterns. The second conductive pattern according to the exemplary embodiment will be described with reference to FIGS. 10, 11, and 12.

According to the embodiment, the first signal line S1 may be configured to transmit a first signal in a first frequency band, and the second signal line S2 may be configured to transmit a second signal in a second frequency band different from the first frequency band.

According to the embodiment, when signals are transmitted through the first signal line S1 and the second signal line S2, the first filter F1 and the second filter F2 may reduce an electromagnetic effect (e.g., electromagnetic interference (EMI) or crosstalk) between the first signal line S1 and the second signal line S2. When signals are transmitted through the first signal line S1 and the second signal line S2, the first filter F1 and the second filter F2 may be configured to have designated electromagnetic isolation between the first signal line S1 and the second signal line S2. The 'designated electromagnetic isolation' may refer to an isolation level for ensuring or improving signal integrity by reducing a loss or deformation of the first signal in the first frequency band, which is transmitted through the first signal line S1, and the second signal in the second frequency band transmitted through the second signal line S2.

According to the embodiment, when signals are transmitted through the first signal line S1 and the second signal line S2, the first filter F1 and the second filter F2 may ensure or improve the isolation between the first signal line S1 and the second signal line S2 by reducing energy (or electromagnetic wave energy) transmitted (excited) to the first signal line S1 and the second signal line S2 by electromagnetic coupling between the first signal line S1 and the second signal line S2.

According to the embodiment, when signals are transmitted through the first signal line S1 and the second signal line S2, the first filter F1 and the second filter F2 may reduce or substantially eliminate noise (or noise components) in a particular frequency band that may be generated by electromagnetic coupling between the first signal line S1 and the second signal line S2.

According to the embodiment, the first filter F1 may include a first notch filter implemented by the first conductive pattern (e.g., a first conductive pattern 8 in FIG. 7). The first notch filter may be configured to have a frequency response in order to allow the first signal in the desired first frequency band to pass through the first notch filter, reduce a degree to which the second signal in an undesired (or unnecessary) second frequency band passes through the first notch filter, and/or substantially prevent the second signal in an undesired (or unnecessary) second frequency band from passing through the first notch filter. The first notch filter may concentrate energy of the undesired second frequency band on the first frequency band used by the first signal line S1.

According to the embodiment, when the first signal in the first frequency band is transmitted through the first signal line S1 and the second signal in the second frequency band is transmitted through the second signal line S2, the first filter F1 may ensure or improve a power gain for the first signal line S1 in the first frequency band by reducing the electromagnetic effect applied to the first signal line S1 by the second signal line S2. The first filter F1 may reduce the electromagnetic effect applied to the first signal line S1 by the second signal line S2 by reducing a loss of power for the first signal in the first frequency band transmitted through the first signal line S1 and efficiently transmitting the signal.

According to the embodiment, when the first signal in the first frequency band is transmitted through the first signal line S1 and the second signal in the second frequency band is transmitted through the second signal line S2, the first filter F1 may ensure or improve matching between input impedance and output impedance for the first signal line S1 by reducing the electromagnetic effect applied to the first signal line S1 by the second signal line S2.

According to the embodiment, the second filter F2 may include a second notch filter implemented by the second conductive pattern (e.g., a second conductive pattern 1000 in FIG. 10). The second notch filter may be configured to have a frequency response in order to allow the second signal in the desired second frequency band to pass through the second notch filter, reduce a degree to which the first signal in an undesired (or unnecessary) first frequency band passes through the second notch filter, and/or substantially prevent the first signal in an undesired (or unnecessary) first frequency band from passing through the second notch filter. The second notch filter may concentrate energy of the undesired first frequency band on the second frequency band used by the second signal line S2.

According to the embodiment, when the first signal in the first frequency band is transmitted through the first signal line S1 and the second signal in the second frequency band is transmitted through the second signal line S2, the second filter F2 may ensure or improve a power gain for the second signal line S2 in the second frequency band by reducing the electromagnetic effect applied to the second signal line S2 by the first signal line S1. The second filter F2 may reduce the electromagnetic effect applied to the second signal line S2 by the first signal line S1 by reducing a loss of power for the second signal in the second frequency band transmitted through the second signal line S2 and efficiently transmitting the signal.

According to the embodiment, when the first signal in the first frequency band is transmitted through the first signal line S1 and the second signal in the second frequency band is transmitted through the second signal line S2, the second filter F2 may ensure or improve matching between input impedance and output impedance for the second signal line S2 by reducing the electromagnetic effect applied to the second signal line S2 by the first signal line S 1.

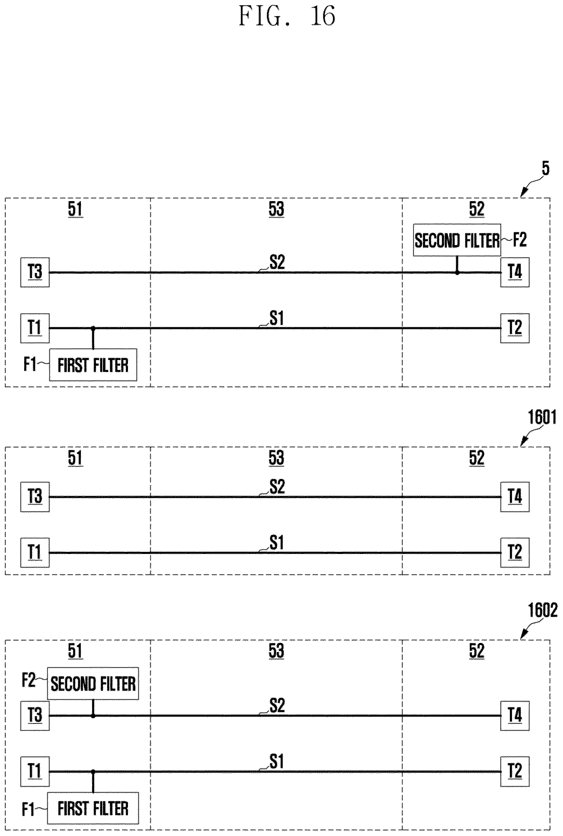

There may be a flexible printed circuit board of a comparative example in which the first filter F1, which is electrically connected to the first signal line S 1, and the second filter F2, which is electrically connected to the second signal line S2, are disposed on the first part 51 or the second part 52. In comparison with the flexible printed circuit board 5 according to the embodiment of the disclosure, it is difficult for the flexible printed circuit board (e.g., a flexible printed circuit board 1601 or 1602 in FIG. 16) according to the comparative example to ensure designated electromagnetic isolation between the first signal line S1 and the second signal line S2 because of electromagnetic coupling between the first filter F1 and the second filter F2. In the flexible printed circuit board 5 according to the embodiment of the disclosure, the first filter F1 is included in the first part 51, and the second filter F2 is included in the second part 52. Therefore, in comparison with the flexible printed circuit board of the comparative example, the flexible printed circuit board 5 according to the embodiment of the disclosure may not substantially generate the electromagnetic coupling between the first filter F1 and the second filter F2 and the deterioration in isolation caused by the electromagnetic coupling.

According to the embodiment, one of the first signal line S1 and the second signal line S2 may be configured to transmit a transmission signal (e.g., an Rx signal), and the other of the first signal line S1 and the second signal line S2 may be configured to transmit a reception signal (e.g., a Tx signal). The transmission signal and the reception signal may be respectively included in different frequency bands. Because intensity of the transmission signal (e.g., a magnitude of power) may be higher than intensity of the reception signal, one signal line for transmitting the transmission signal under the electromagnetic interference between the first signal line S1 and the second signal line S2 may be defined or interpreted as an 'aggressor line', and the other signal line for transmitting the reception signal may be defined or interpreted as a 'victim line'.

According to the embodiment, the second terminal T2 may be used as a first input terminal (or a first input end) configured to input the first signal (e.g., the transmission signal) in the first frequency band, and the first terminal T1 may be used as a first output terminal (or a first output end) configured to output the first signal. The third terminal T3 may be used as a second input terminal (or a second input end) configured to input the second signal (e.g., the reception signal) in the second frequency band, and the fourth terminal T4 may be used as a second output terminal (or a second output end) configured to output the second signal. The first filter F1 (e.g., the first notch filter) may have the frequency response that allows the first signal in the first frequency band to pass through the first filter, reduces a degree to which the second signal in an undesired (or unnecessary) second frequency band passes through the first filter, and/or substantially prevents the second signal in an undesired (or unnecessary) second frequency band from passing through the first filter. The first filter F1 may be disposed on the first part 51 including the first output terminal (e.g., the first terminal T1). The second filter F2 (e.g., second notch filter) may have the frequency response that allows the second signal in the second frequency band to pass through the second filter, reduces a degree to which the first signal in an undesired (or unnecessary) first frequency band passes through the second filter, and/or substantially prevents the first signal in an undesired (or unnecessary) first frequency band from passing through the second filter. The second filter F2 may be disposed on the second part 52 including the second output terminal (e.g., the fourth terminal T4). Because the first filter F1 is disposed on the first part 51 including the first output terminal (e.g., the first terminal T1) and the second filter F2 is disposed on the second part 52 including the second output terminal (e.g., the fourth terminal T4), the electromagnetic coupling may not substantially occur between the first filter F1 and the second filter F2, and the deterioration in isolation caused by the electromagnetic coupling may not substantially occur.

According to various embodiments, the first terminal T1 may be used as the first input terminal (or the first input end) configured to input the first signal (e.g., the transmission signal) in the first frequency band, and the second terminal T2 may be the second output terminal (or the second output end) configured to output the first signal. The fourth terminal T4 may be used as the second input terminal (or the second input end) configured to input the second signal (e.g., the reception signal) in the second frequency band, and the third terminal T3 may be used as the second output terminal (or the second output end) configured to output the second signal. The first filter F1 (e.g., the first notch filter) may have the frequency response that allows the first signal in the first frequency band to pass through the first filter, reduces a degree to which the second signal in an undesired (or unnecessary) second frequency band passes through the first filter, and/or substantially prevents the second signal in an undesired (or unnecessary) second frequency band from passing through the first filter. The first filter F1 may be disposed on the first part 51 including the first input terminal (e.g., the first terminal T1). The second filter F2 (e.g., second notch filter) may have the frequency response that allows the second signal in the second frequency band to pass through the second filter, reduces a degree to which the first signal in an undesired (or unnecessary) first frequency band passes through the second filter, and/or substantially prevents the first signal in an undesired (or unnecessary) first frequency band from passing through the second filter. The second filter F2 may be disposed on the second part 52 including the second input terminal (e.g., the fourth terminal T4). Because the first filter F1 is disposed on the first part 51 including the first input terminal (e.g., the first terminal T1) and the second filter F2 is disposed on the second part 52 including the second input terminal (e.g., the fourth terminal T4), the electromagnetic coupling may not substantially occur between the first filter F1 and the second filter F2, and the deterioration in isolation caused by the electromagnetic coupling may not substantially occur.

In order to more easily describe the contents of the technology and assist in understanding the disclosure, the exemplary embodiment is merely provided to reduce the electromagnetic effect between the without signal lines (e.g., the first signal line S1 and the second signal line S2) that may apply the electromagnetic effect to each other. Therefore, substantially the same method may be applied to two other signal lines included in the flexible printed circuit board 5.

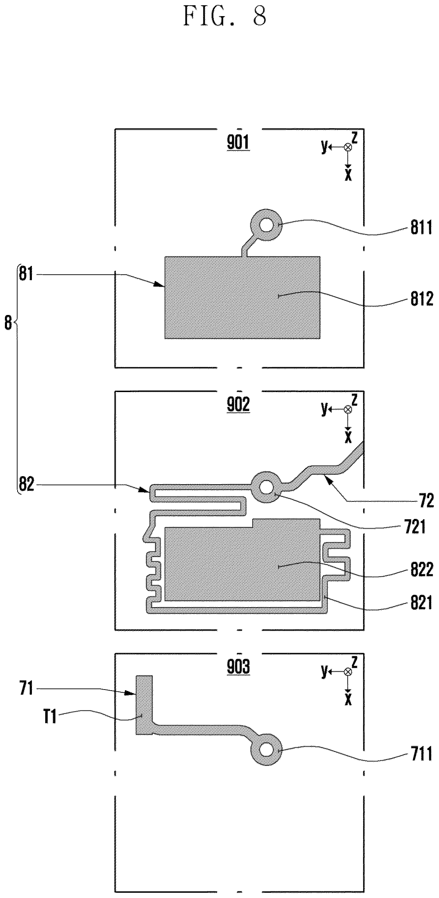

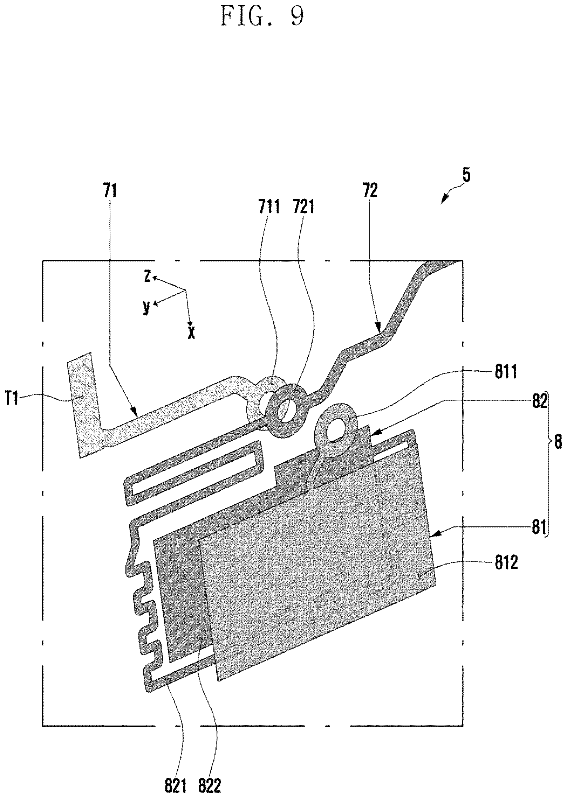

FIG. 7 is a view illustrating part 'C' in FIG. 5 of the flexible printed circuit board 5 according to the embodiment of the disclosure. FIG. 8 is a view illustrating a plurality of pattern layers of the flexible printed circuit board 5 according to the embodiment of the disclosure. FIG. 9 is a perspective view illustrating a part of the flexible printed circuit board 5 according to the embodiment of the disclosure. It is to be understood at the present disclosure envisages and includes all combinations of features and/or embodiments disclosed in relation to FIGS. 7, 8, and 9. That is, every combination of the features described below in relation to FIGS. 7, 8, and 9 should be considered as included in the present disclosure as a specific example.

With reference to FIGS. 7, 8, and 9, the flexible printed circuit board 5 may include a first signal line pattern 71, a second signal line pattern 72, a third signal line pattern 73, a fourth signal line pattern 74, the first conductive pattern 8, a first conductive via V1, a second conductive via V2, and/or a plurality of third conductive vias V3.

According to the embodiment, the first signal line pattern 71 may be a part of the first signal line S1 (see FIG. 6) and included in the first part 51. One end of the first signal line pattern 71 may include the first terminal T1.

According to the embodiment, the second signal line pattern 72 may be a part of the first signal line S1 (see FIG. 6) and extend from the first part 51 to the third part 53.

According to the embodiment, the first signal line pattern 71 and the second signal line pattern 72 may be respectively included in different pattern layers of the flexible printed circuit board 5 and electrically connected through the first conductive via V1. The first signal line pattern 71 may include a third via connection portion 711 extending from the first terminal T1. The second signal line pattern 72 may include a second via connection portion 721 corresponding to the third via connection portion 711. The second via connection portion 721 and the third via connection portion 711 may be electrically connected through the first conductive via V1.

According to the embodiment, the third signal line pattern 73 may be a part of the second signal line S2 (see FIG. 6) and included in the first part 51. One end of the third signal line pattern 73 may include the third terminal T3.

According to the embodiment, the fourth signal line pattern 74 may be a part of the second signal line S2 (see FIG. 6) and extend from the first part 51 to the third part 53.

According to the embodiment, the third signal line pattern 73 and the fourth signal line pattern 74 may be respectively included in different pattern layers of the flexible printed circuit board 5 and electrically connected through the second conductive via V2.

According to the embodiment, the first conductive pattern 8 may be electrically connected to the first signal line S1 (see FIG. 6) through the first conductive via V1. The first conductive pattern 8 may define the first filter F1 (see FIG. 6).

According to the embodiment, the first conductive pattern 8 may include a first partially conductive pattern 81 and a second partially conductive pattern 82. The first partially conductive pattern 81 and the second partially conductive pattern 82 may be respectively included in different pattern layers of the flexible printed circuit board 5 and electrically connected through the first conductive via V1.

According to the embodiment, the flexible printed circuit board 5 may include a first pattern layer 901, a second pattern layer 902, and/or a third pattern layer 903. The second pattern layer 902 may be positioned between the first pattern layer 901 and the third pattern layer 903. The flexible printed circuit board 5 may include a first insulating layer (not illustrated separately) disposed between the first pattern layer 901 and the second pattern layer 902, and a second insulating layer (not illustrated separately) disposed between the second pattern layer 902 and the third pattern layer 903.

According to the embodiment, the first pattern layer 901 may include the first partially conductive pattern 81 of the first conductive pattern 8.

According to the embodiment, the second pattern layer 902 may include the second signal line pattern 72 and the second partially conductive pattern 82 of the first conductive pattern 8. It is possible to provide (or define) an integrated or single pattern (e.g., a single continuous pattern) including the second signal line pattern 72 and the second partially conductive pattern 82.

According to the embodiment, the first pattern layer 901 or the second pattern layer 902 may include the fourth signal line pattern 74.

According to the embodiment, the third pattern layer 903 may include the first signal line pattern 71 and/or the third signal line pattern 73.

According to the embodiment, the first partially conductive pattern 81 of the first conductive pattern 8 may include a first via connection portion 811, and a first plane 812 extending from the first via connection portion 811. The first via connection portion 811, the second via connection portion 721, and the third via connection portion 711 may be electrically connected through the first conductive via V1.

According to the embodiment, the second partially conductive pattern 82 of the first conductive pattern 8 may include a first trace 821 extending from the second via connection portion 721, and/or a second plane 822 extending from the first trace 821.

According to the embodiment, the first plane 812 of the first partially conductive pattern 81 and the second plane 822 of the second partially conductive pattern 82 may be disposed to face each other. When viewed from above the first plane 812, the first plane 812 and the second plane 822 may at least partially overlap each other. The first plane 812 and the second plane 822 may be substantially parallel. When signals are transmitted through the first signal line S1 (see FIG. 6) and the second signal line S2 (see FIG. 6), the first conductive pattern 8 may apply capacitance between the first signal line S1 and the second signal line S2 through electromagnetic coupling between the first plane 812 and the second plane 822.

According to the embodiment, the first trace 821 of the second partially conductive pattern 82 may extend from the second plane 822 without overlapping the first plane 812 when viewed from above the first pattern layer 901. When signals are transmitted through the first signal line S1 (see FIG. 6) and the second signal line S2 (see FIG. 6), the first conductive pattern 8 may apply inductance between the first signal line S1 and the second signal line S2 through the first trace 821.

According to various embodiments, although not illustrated separately, the first partially conductive pattern 81 may be implemented in the form including the first trace 821 that connects the first via connection portion 811 and the first plane 812, and the second partially conductive pattern 82 may be implemented in the form excluding the first trace 821.

According to various embodiments, when signals are transmitted through the first signal line S1 (see FIG. 6) and the second signal line S2 (see FIG. 6), the first conductive pattern 8 may be provided (or formed) in various other forms (not illustrated separately), which are not limited to the illustrated example, in order to apply the element value, such as inductance, capacitance, and/or conductance, between the first signal line S1 and the second signal line S2.

According to the embodiment, the plurality of third conductive vias V3 may be included in the first part 51 of the flexible printed circuit board 5. The plurality of third conductive vias V3 may electrically connect a plurality of ground patterns included in different pattern layers of the flexible printed circuit board 5. The plurality of third conductive vias V3 may electrically connect at least two ground patterns among a first ground pattern (not illustrated separately) of the first pattern layer 901 at least partially included in the first part 51, a second ground pattern (not illustrated separately) of the second pattern layer 902 at least partially included in the first part 51, and a third ground pattern (not illustrated separately) of the third pattern layer 903 at least partially included in the first part 51. A combination of the plurality of third conductive vias V3 and the plurality of ground patterns may be physically separated from the first signal line S1 (see FIG. 6) and the second signal line S2 (see FIG. 6). The combination of the plurality of third conductive vias V3 and the plurality of ground patterns may reduce electromagnetic interference (EMI) or crosstalk between the first signal line S1 (see FIG. 6) and the second signal line S2 (see FIG. 6) and reduce or block the electromagnetic interference applied to the first signal line S1 and the second signal line S2 by noise from the outside of the flexible printed circuit board 5.

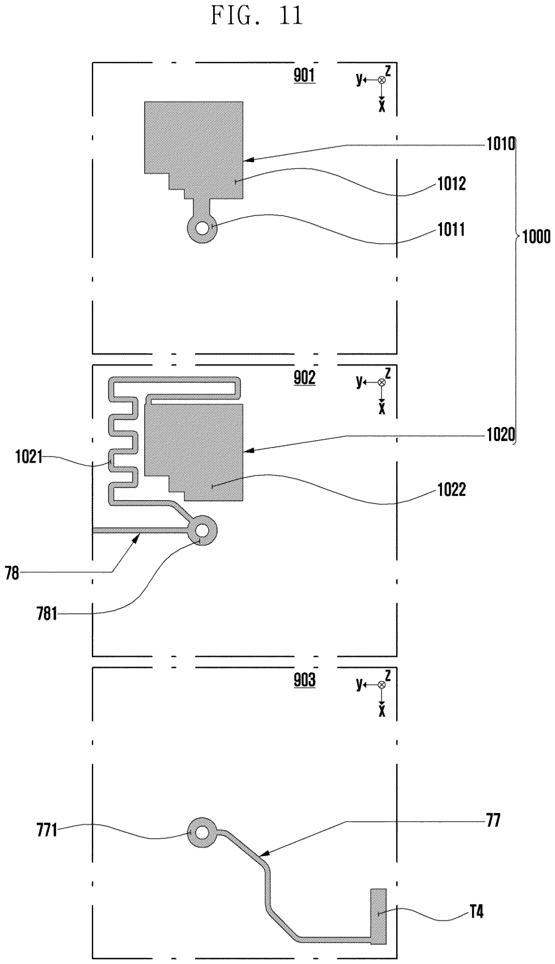

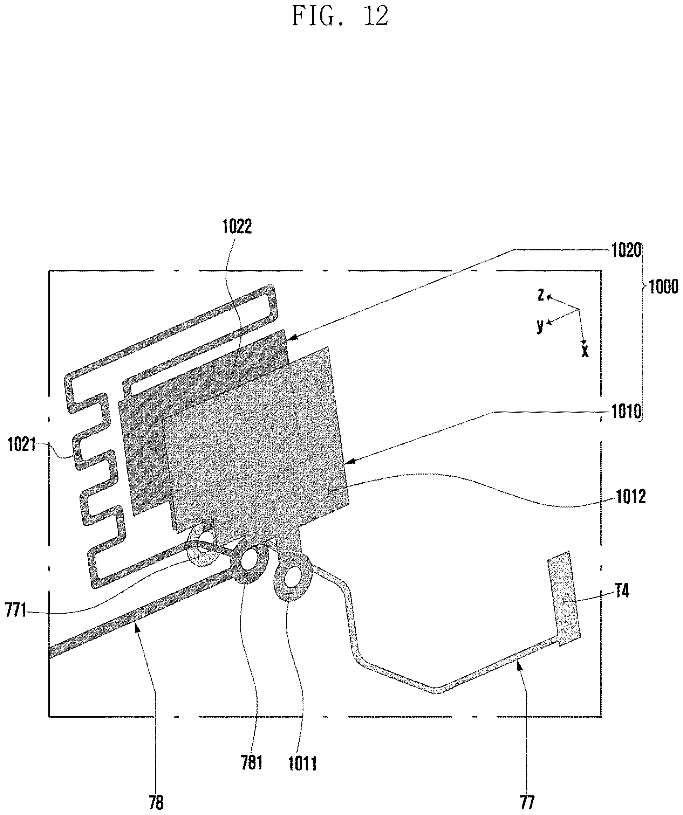

FIG. 10 is a view illustrating part 'D' in FIG. 5 of the flexible printed circuit board 5 according to the embodiment of the disclosure. FIG. 11 is a view illustrating a plurality of pattern layers of the flexible printed circuit board 5 according to the embodiment of the disclosure. FIG. 12 is a perspective view illustrating a part of the flexible printed circuit board 5 according to the embodiment of the disclosure. It is to be understood at the present disclosure envisages and includes all combinations of features and/or embodiments disclosed in relation to FIGS. 10, 11, and 12. That is, every combination of the features described below in relation to FIGS. 10, 11, and 12 should be considered as included in the present disclosure as a specific example.

With reference to FIGS. 10, 11, and 12, the flexible printed circuit board 5 may include a fifth signal line pattern 75, a sixth signal line pattern 76, a seventh signal line pattern 77, an eighth signal line pattern 78, the second conductive pattern 1000, a fourth conductive via V4, a fifth conductive via V5, and/or a plurality of sixth conductive vias V6.

According to the embodiment, the fifth signal line pattern 75 may be a part of the first signal line S1 (see FIG. 6) and included in the second part 52. One end of the fifth signal line pattern 75 may include the second terminal T2.

According to the embodiment, the sixth signal line pattern 76 may be a part of the first signal line S1 (see FIG. 6) and extend from the second part 52 to the third part 53.

According to the embodiment, the second signal line pattern 72 (see FIG. 7) and the sixth signal line pattern 76 may be included in the same pattern layer (e.g., the second pattern layer 902) of the flexible printed circuit board 5. It is possible to provide (or define) an integrated or single pattern (e.g., a single continuous pattern) including the second signal line pattern 72 (see FIG. 7) and the sixth signal line pattern 76.

According to the embodiment, the fifth signal line pattern 75 and the sixth signal line pattern 76 may be respectively included in different pattern layers of the flexible printed circuit board 5 and electrically connected through the fourth conductive via V4.

According to the embodiment, the seventh signal line pattern 77 may be a part of the second signal line S2 (see FIG. 6) and included in the second part 52. One end of the seventh signal line pattern 77 may include the fourth terminal T4.

According to the embodiment, the eighth signal line pattern 78 may be a part of the second signal line S2 (see FIG. 6) and extend from the second part 52 to the third part 53.

According to the embodiment, the fourth signal line pattern 74 (see FIG. 7) and the eighth signal line pattern 78 may be included in the same pattern layer (e.g., the second pattern layer 902) of the flexible printed circuit board 5. It is possible to provide (or define) an integrated or single pattern (e.g., a single continuous pattern) including the fourth signal line pattern 74 (see FIG. 7) and the eighth signal line pattern 78.

According to the embodiment, the seventh signal line pattern 77 and the eighth signal line pattern 78 may be respectively included in different pattern layers of the flexible printed circuit board 5 and electrically connected through the fifth conductive via V5. The seventh signal line pattern 77 may include a sixth via connection portion 771 extending from the fourth terminal T4. The eighth signal line pattern 78 may include a fifth via connection portion 781 corresponding to the sixth via connection portion 771. The fifth via connection portion 781 and the sixth via connection portion 771 may be electrically connected through the fifth conductive via V5.

According to the embodiment, the second conductive pattern 1000 may be electrically connected to the second signal line S2 (see FIG. 6) through the fifth conductive via V5. The second conductive pattern 1000 may define the second filter F2 (see FIG. 6).

According to the embodiment, the second conductive pattern 1000 may include a third partially conductive pattern 1010 and a fourth partially conductive pattern 1020. The third partially conductive pattern 1010 and the fourth partially conductive pattern 1020 may be respectively included in different pattern layers of the flexible printed circuit board 5 and electrically connected through the fifth conductive via V5.

According to the embodiment, the first pattern layer 901 may include the third partially conductive pattern 1010 of the second conductive pattern 1000.

According to the embodiment, the second pattern layer 902 may include the eighth signal line pattern 78 and the fourth partially conductive pattern 1020 of the second conductive pattern 1000. It is possible to provide (or define) an integrated or single pattern (e.g., a single continuous pattern) including the eighth signal line pattern 78 and the fourth partially conductive pattern 1020.

According to the embodiment, the first pattern layer 901 or the second pattern layer 902 may include the sixth signal line pattern 76.

According to the embodiment, the third pattern layer 903 may include the fifth signal line pattern 75 and/or the seventh signal line pattern 77.

According to the embodiment, the third partially conductive pattern 1010 of the second conductive pattern 1000 may include a fourth via connection portion 1011, and a third plane 1012 extending from the fourth via connection portion 1011. The fourth via connection portion 1011, the fifth via connection portion 781, and the sixth via connection portion 771 may be electrically connected through the fifth conductive via V5.

According to the embodiment, the fourth partially conductive pattern 1020 of the second conductive pattern 1000 may include a second trace 1021 extending from the fifth via connection portion 781, and/or a fourth plane 1022 extending from the second trace 1021.

According to the embodiment, the third plane 1012 of the third partially conductive pattern 1010 and the fourth plane 1022 of the fourth partially conductive pattern 1020 may be disposed to face each other. When viewed from above the third plane 1012, the third plane 1012 and the fourth plane 1022 may at least partially overlap each other. The third plane 1012 and the fourth plane 1022 may be substantially parallel. When signals are transmitted through the first signal line S1 (see FIG. 6) and the second signal line S2 (see FIG. 6), the second conductive pattern 1000 may apply capacitance between the first signal line S1 and the second signal line S2 through electromagnetic coupling between the third plane 1012 and the fourth plane 1022.

According to the embodiment, the second trace 1021 of the fourth partially conductive pattern 1020 may extend from the fourth plane 1022 without overlapping the third plane 1012 when viewed from above the first pattern layer 901. When signals are transmitted through the first signal line S1 (see FIG. 6) and the second signal line S2 (see FIG. 6), the second conductive pattern 1000 may apply inductance between the first signal line S1 and the second signal line S2 through the second trace 1021.

According to various embodiments, although not illustrated separately, the third partially conductive pattern 1010 may be implemented in the form including the second trace 1021 that connects the fourth via connection portion 1011 and the third plane 1012, and the fourth partially conductive pattern 1020 may be implemented in the form excluding the first trace 1021.

According to various embodiments, when signals are transmitted through the first signal line S1 (see FIG. 6) and the second signal line S2 (see FIG. 6), the second conductive pattern 1000 may be provided (or formed) in various other forms (not illustrated separately), which are not limited to the illustrated example, in order to apply the element value, such as inductance, capacitance, and/or conductance, between the first signal line S1 and the second signal line S2.

According to the embodiment, the plurality of sixth conductive vias V6 may be included in the second part 52 of the flexible printed circuit board 5. The plurality of sixth conductive vias V6 may electrically connect a plurality of ground patterns included in different pattern layers of the flexible printed circuit board 5. The plurality of sixth conductive vias V6 may electrically connect at least two ground patterns among a fourth ground pattern (not illustrated separately) of the first pattern layer 901 at least partially included in the second part 52, a fifth ground pattern (not illustrated separately) of the second pattern layer 902 at least partially included in the second part 52, and a sixth ground pattern (not illustrated separately) of the third pattern layer 903 at least partially included in the second part 52. A combination of the plurality of sixth conductive vias V6 and the plurality of ground patterns may be physically separated from the first signal line S1 (see FIG. 6) and the second signal line S2 (see FIG. 6). The combination of the plurality of sixth conductive vias V6 and the plurality of ground patterns may reduce electromagnetic interference (EMI) or crosstalk between the first signal line S1 (see FIG. 6) and the second signal line S2 (see FIG. 6) and reduce or block the electromagnetic interference applied to the first signal line S1 and the second signal line S2 by noise from the outside of the flexible printed circuit board 5.

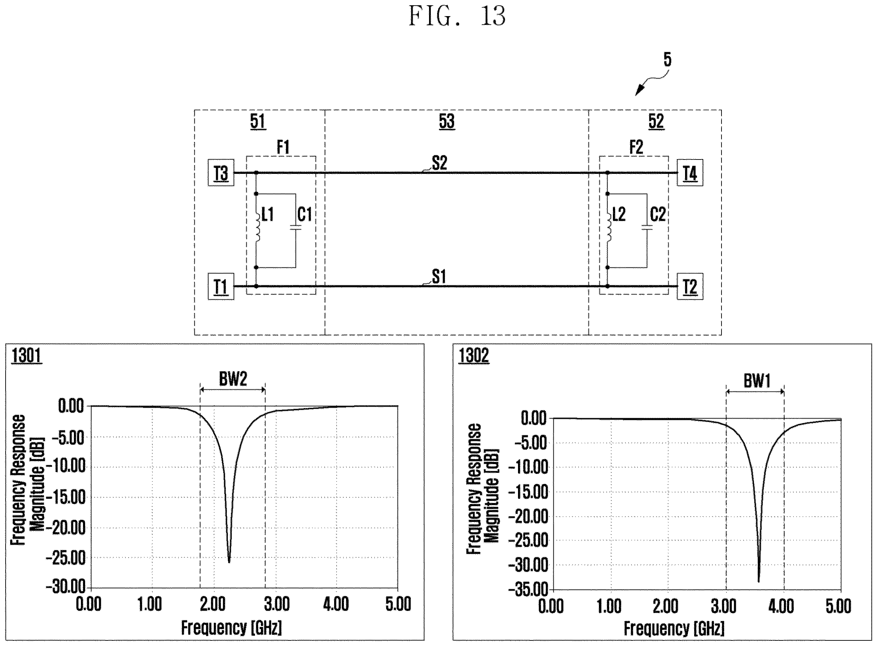

FIG. 13 is a view illustrating an equivalent circuit diagram of the flexible printed circuit board 5 including the first filter F1 and the second filter F2 according to the embodiment of the disclosure, a graph 1301 illustrating frequency response characteristics of the first filter F1, and a graph 1302 illustrating frequency response characteristics of the second filter F2.

With reference to FIG. 13, the first filter F1 may include a first notch filter (e.g., a first micro-strip notch filter) included in the first part 51 of the flexible printed circuit board 5 and implemented by the first conductive pattern 8 (see FIG. 7). When a first signal in a first frequency band BW1 (e.g., about 3 GHz to about 4 GHz) is transmitted through the first signal line S1 and a second signal in a second frequency band BW2 (e.g., about 1.8 GHz to about 2.8 GHz) is transmitted through the second signal line S2, the first notch filter may have a frequency response that allows the first signal in the desired first frequency band BW1 to pass through the first notch filter, reduces a degree to which the second signal in an undesired second frequency band BW2 passes through the first notch filter, and/or substantially prevents the second signal in an undesired second frequency band BW2 from passing through the first notch filter.

According to the embodiment, the second filter F2 may include a second notch filter (e.g., a second micro-strip notch filter) included in the second part 52 of the flexible printed circuit board 5 and implemented by the second conductive pattern 1000 (see FIG. 10). When the first signal in the first frequency band BW1 is transmitted through the first signal line S1 and the second signal in the second frequency band BW2 is transmitted through the second signal line S2, the second notch filter may have a frequency response that allows the second signal in the desired the second frequency band BW2 to pass through the second notch filter, reduces a degree to which the first signal in an undesired first frequency band BW1 passes through the second notch filter, and/or substantially prevents the first signal in an undesired first frequency band BW 1 from passing through the second notch filter.

According to the embodiment, the first signal with the first frequency (e.g., about 3.5 GHz) may be transmitted through the first signal line S1, and the second signal with the second frequency (e.g., about 2.35 GHz) may be transmitted through the second signal line S2. The first filter (e.g., the first notch filter) F1 may reduce the electromagnetic effect applied to the first signal line S1 by the second signal with the second frequency. The first filter F1 may have the frequency response that substantially block the second signal with the second frequency by means of a combination of a first capacitance C1 and a first inductance L1. The second filter (e.g., the second notch filter) F2 may reduce the electromagnetic effect applied to the second signal line S2 by the first signal with the first frequency. The second filter F2 may have the frequency response that substantially blocks the first signal with the first frequency by means of a combination of a second capacitance C2 and a second inductance L2.

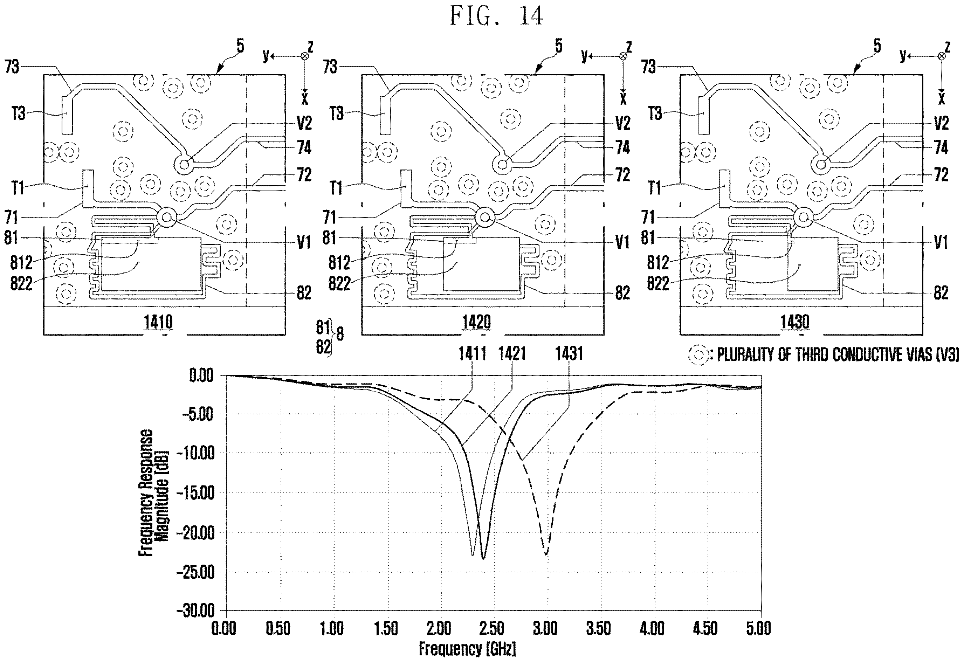

FIG. 14 is a view illustrating a part of the flexible printed circuit board 5 according to various embodiments of the disclosure and graphs illustrating frequency response characteristics according to the first conductive pattern 8.

With reference to FIG. 14, the flexible printed circuit board 5 may include the first signal line pattern 71, the second signal line pattern 72, the third signal line pattern 73, the fourth signal line pattern 74, the first conductive pattern 8, the first conductive via V1, the second conductive via V2, and/or the plurality of third conductive vias V3. The first conductive pattern 8 may include the first partially conductive pattern 81 and the second partially conductive pattern 82.

According to the embodiment, a first exemplary embodiment 1410 may include the flexible printed circuit board 5 in which the first plane 812 of the first partially conductive pattern 81 and the second plane 822 of the second partially conductive pattern 82 overlap each other by a first area. A second exemplary embodiment 1420 may include the flexible printed circuit board 5 in which the first plane 812 of the first partially conductive pattern 81 and the second plane 822 of the second partially conductive pattern 82 overlap each other by a second area smaller than the first area. A third exemplary embodiment 1430 may include the flexible printed circuit board 5 in which the first plane 812 of the first partially conductive pattern 81 and the second plane 822 of the second partially conductive pattern 82 overlap each other by a third area smaller than the second area. The shape and/or size of the first plane 812 and the second plane 822 overlapping each other may be implemented to form the first capacitance C1 according to the exemplary embodiment in FIG. 13.

According to the embodiment, a graph 1411 is a graph illustrating frequency response characteristics of the first filter F1 (see FIG. 6) implemented by the first conductive pattern 8 according to the first exemplary embodiment 1410. A graph 1421 is a graph illustrating frequency response characteristics of the first filter F1 (see FIG. 6) implemented by the first conductive pattern 8 according to the second exemplary embodiment 1420. A graph 1431 is a graph illustrating frequency response characteristics of the first filter F1 (see FIG. 6) implemented by the first conductive pattern 8 according to the third exemplary embodiment 1430. The graph 1411, the graph 1421, and the graph 1431 show that the frequency band, which substantially blocks the signal, varies as the capacitance (e.g., the first capacitance C1 in FIG. 13) varies according to the first exemplary embodiment 1410, the second exemplary embodiment 1420, and the third exemplary embodiment 1430. For example, the first conductive pattern 8 according to the first exemplary embodiment 1410 may have frequency response characteristics that may substantially block a signal in a particular frequency band having a resonance point of about 2.3 GHz. For example, the first conductive pattern 8 according to the second exemplary embodiment 1420 may have frequency response characteristics that may substantially block a signal in a particular frequency band having a resonance point of about 2.4 GHz. For example, the first conductive pattern 8 according to the third exemplary embodiment 1430 may have frequency response characteristics that may substantially block a signal in a particular frequency band having a resonance point of about 3.0 GHz.

According to the embodiment, the shape or size of the third plane 1012 (see FIG. 12) and the fourth plane 1022 of the second conductive pattern 1000 (see FIG. 12) included in the second part 52 of the flexible printed circuit board 5 may be implemented to form the second capacitance C2 according to the exemplary embodiment in FIG. 13.

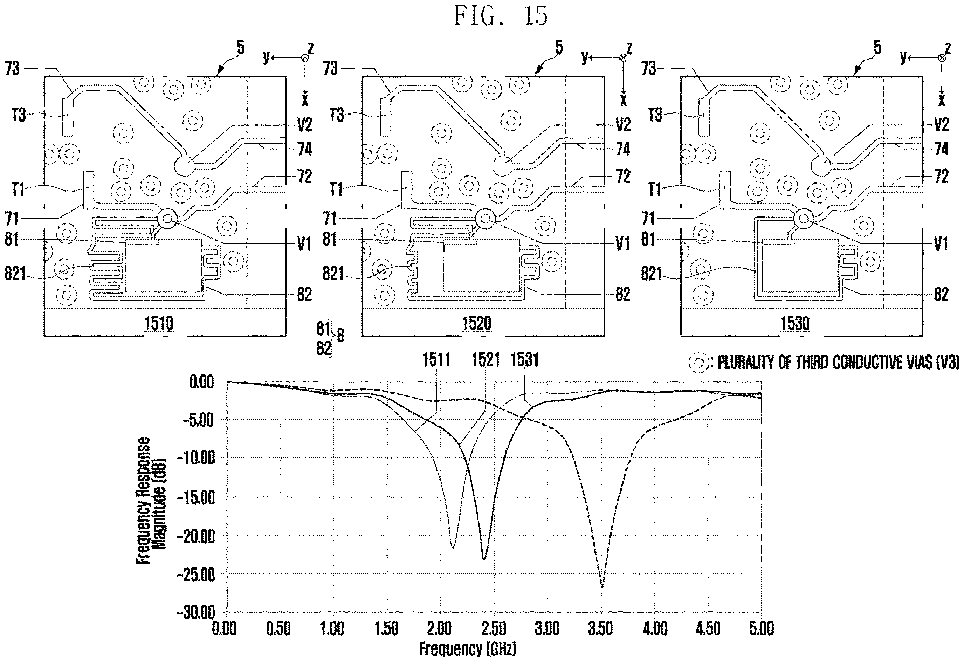

FIG. 15 is a view illustrating a part of the flexible printed circuit board 5 according to various embodiments of the disclosure and graphs illustrating frequency response characteristics according to the first conductive pattern 8.

With reference to FIG. 15, the flexible printed circuit board 5 may include the first signal line pattern 71, the second signal line pattern 72, the third signal line pattern 73, the fourth signal line pattern 74, the first conductive pattern 8, the first conductive via V1, the second conductive via V2, and/or the plurality of third conductive vias V3. The first conductive pattern 8 may include the first partially conductive pattern 81 and the second partially conductive pattern 82.

According to the embodiment, a fourth exemplary embodiment 1510 may include the flexible printed circuit board 5 in which the first trace 821 of the second partially conductive pattern 82 is implemented in a first form having a first length. A fifth exemplary embodiment 1520 may include the flexible printed circuit board 5 in which the first trace 821 of the second partially conductive pattern 82 is implemented in a second form having a second length shorter than the first length. A sixth exemplary embodiment 1530 may include the flexible printed circuit board 5 in which the first trace 821 of the second partially conductive pattern 82 is implemented in a third form having a third length shorter than the second length. The length and/or shape of the first trace 821 may be implemented to form the first inductance L1 according to the exemplary embodiment in FIG. 13.

According to the embodiment, a graph 1511 is a graph illustrating frequency response characteristics of the first filter F1 (see FIG. 6) implemented by the first conductive pattern 8 according to the fourth exemplary embodiment 1510. A graph 1521 is a graph illustrating frequency response characteristics of the first filter F1 (see FIG. 6) implemented by the first conductive pattern 8 according to the fifth exemplary embodiment 1520. A graph 1531 is a graph illustrating frequency response characteristics of the first filter F1 (see FIG. 6) implemented by the first conductive pattern 8 according to the sixth exemplary embodiment 1530. The graph 1511, the graph 1521, and the graph 1531 show that the frequency band, which substantially blocks the signal, varies as the inductance (e.g., the first inductance L1 in FIG. 13) varies according to the fourth exemplary embodiment 1510, the fifth exemplary embodiment 1520, and the sixth exemplary embodiment 1530. For example, the first conductive pattern 8 according to the fourth exemplary embodiment 1510 may have frequency response characteristics that may substantially block a signal in a particular frequency band having a resonance point of about 2.1 GHz. For example, the first conductive pattern 8 according to the fifth exemplary embodiment 1520 may have frequency response characteristics that may substantially block a signal in a particular frequency band having a resonance point of about 2.4 GHz. For example, the first conductive pattern 8 according to the sixth exemplary embodiment 1530 may have frequency response characteristics that may substantially block a signal in a particular frequency band having a resonance point of about 3.5 GHz.

According to the embodiment, the length and/or shape of the second trace 1021 of the second conductive pattern 1000 (see FIG. 12) included in the second part 52 of the flexible printed circuit board 5 may be implemented to form the second inductance L2 according to the exemplary embodiment in FIG. 13.

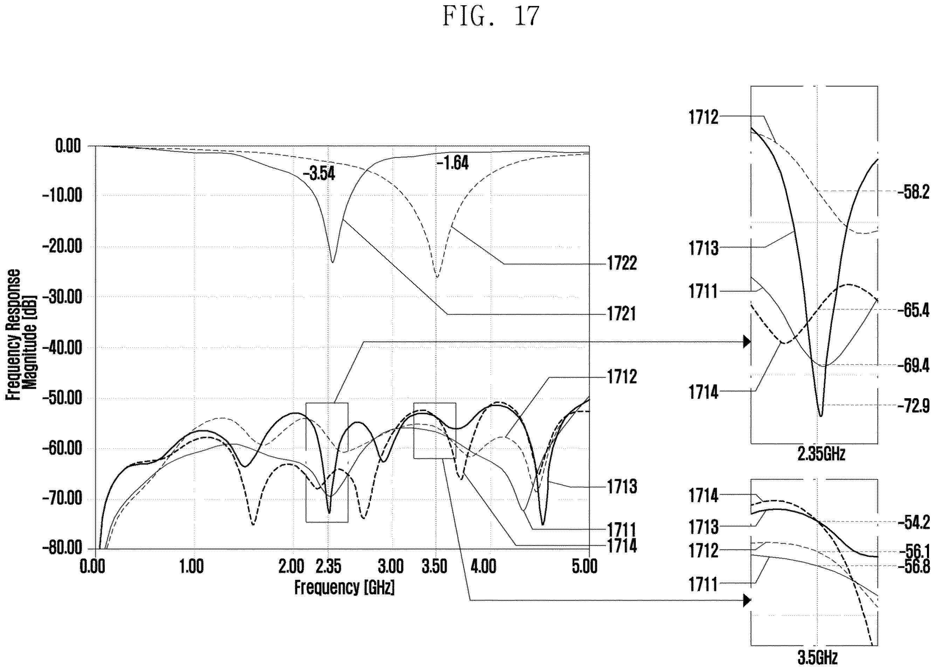

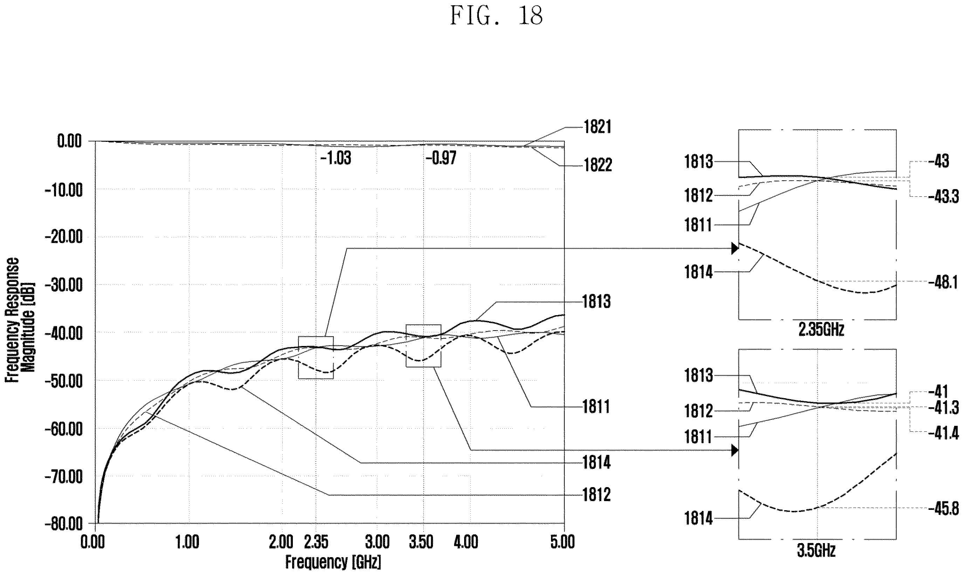

FIG. 16 is a view illustrating a circuit diagram of the flexible printed circuit board 5 according to the embodiment of the disclosure, a circuit diagram of a flexible printed circuit board 1601 according to a first comparative example, and a circuit diagram of a flexible printed circuit board 1602 according to a second comparative example. FIG. 17 is a view illustrating graphs related to isolation and an insertion loss of the flexible printed circuit board 5 according to the embodiment of the disclosure. FIG. 18 is a view illustrating graphs related to isolation and an insertion loss of the flexible printed circuit board 1602 according to the first comparative example.

With reference to FIGS. 16, 17, and 18, the flexible printed circuit board 5 according to the embodiment of the disclosure may include the first filter F1 (e.g., the first notch filter) included in the first part 51 and electrically connected to the first signal line S1, and the second filter F2 (e.g., the second notch filter) included in the second part 52 and electrically connected to the second signal line S2. The flexible printed circuit board 1601 according to the first comparative example may not include the first filter F1 and the second filter F2. The flexible printed circuit board 1602 according to the second comparative example may include the first filter F1 (e.g., the first notch filter) included in the first part 51 and electrically connected to the first signal line S1, and the second filter F2 (e.g., the second notch filter) included in the first part 51 and electrically connected to the second signal line S2.

A graph 1711 illustrates isolation S13 of the flexible printed circuit board 5 according to the embodiment of the disclosure. The isolation S13 indicates undesired power discharged (or leaking) to the third terminal T3 of the second signal line S2 in case that the power is inputted to the first terminal T1 of the first signal line S1. A graph 1712 illustrates isolation S23 of the flexible printed circuit board 5 according to the embodiment of the disclosure. The isolation S23 indicates undesired power discharged (or leaking) to the third terminal T3 of the second signal line S2 in case that the power is inputted to the second terminal T2 of the first signal line S1. A graph 1713 illustrates isolation S41 of the flexible printed circuit board 5 according to the embodiment of the disclosure. The isolation S41 indicates undesired power discharged (or leaking) to the first terminal T1 of the first signal line S1 in case that the power is inputted to the fourth terminal T4 of the second signal line S2. A graph 1714 illustrates isolation S24 of the flexible printed circuit board 5 according to the embodiment of the disclosure. The isolation S24 indicates undesired power discharged (or leaking) to the fourth terminal T4 of the second signal line S2 in case that the power is inputted to the second terminal T2 of the first signal line S1.

A graph 1811 indicates the isolation S13 of the flexible printed circuit board 1601 according to the first comparative example. A graph 1812 indicates the isolation S23 of the flexible printed circuit board 1601 according to the first comparative example. A graph 1813 indicates the isolation S41 of the flexible printed circuit board 1601 according to the first comparative example. A graph 1814 indicates the isolation S24 of the flexible printed circuit board 1601 according to the first comparative example.

Table 1 shows isolations of the flexible printed circuit board 5 according to the embodiment of the disclosure, isolations of the flexible printed circuit board 1601 according to the first comparative example, and isolations of the flexible printed circuit board 1602 according to the second comparative example in case that the first signal with the first frequency (e.g., about 3.5 GHz) is transmitted through the first signal line S1 and the second signal with the second frequency (e.g., about 2.35 GHz) is transmitted through the second signal line S2.

**[Table 1]**

| | Flexible printed circuit board 5 according to embodiment of the disclosure | | Flexible printed circuit board 1601 according to first comparative example | | Flexible printed circuit board 1602 according to second comparative example | | Amount of implemented compared to first comparative example | |
|---|---|---|---|---|---|---|---|---|
| Isolation | 2.35 GHz | 3.5 GHz | 2.35 GHz | 3.5 GHz | 2.35 GHz | 3.5 GHz | 2.35 GHz | 3.5 GHz |
| S13 | -69.4 | -56.8 | -43.3 | -41.4 | **-38** | **-35** | 26.1 | 15.4 |
| S23 | -58.2 | -56.1 | -43.3 | -41.3 | -43 | **-37** | 14.9 | 14.8 |
| S41 | -72.9 | -54.2 | -43 | -41 | -44 | -52 | 29.9 | 13.2 |
| S24 | -65.4 | -54.2 | -48.1 | -45.8 | -59 | -48 | 17.3 | 8.4 |

With reference to Table 1, in comparison with the flexible printed circuit board 1601 of the first comparative example and the flexible printed circuit board 1602 of the first comparative example, the flexible printed circuit board 5 according to the embodiment of the disclosure may improve the isolation between the first signal line S1 and the second signal line S2 by means of the first filter F1 and the second filter F2 when the first signal with the first frequency is transmitted through the first signal line S1 and the second signal with the second frequency is transmitted through the second signal line S2.

The flexible printed circuit board 1602 according to the second comparative example may have the isolation S13 and the isolation S23 smaller than that of the flexible printed circuit board 1601 according to the first comparative example by means of electromagnetic coupling between the first filter F1 and the second filter F2 included in the first part 51. The flexible printed circuit board (not illustrated separately) according to a third comparative example including the first filter F1 and the second filter F2 included in the second part 52 may have the isolation smaller than that of the flexible printed circuit board 1601 according to the first comparative example by means of electromagnetic coupling between the first filter F1 and the second filter F2. In the flexible printed circuit board 5 according to the embodiment of the disclosure, the first filter F1 is included in the first part 51, and the second filter F2 is included in the second part 52. Therefore, the flexible printed circuit board 5 according to the embodiment of the disclosure may not generate the electromagnetic coupling between the first filter F1 and the second filter F2 and the deterioration in isolation caused by the electromagnetic coupling in comparison with the flexible printed circuit board 1602 according to the second comparative example (or the flexible printed circuit board according to the third comparative example).

A graph 1721 illustrates an insertion loss S21 of the flexible printed circuit board 5 according to the embodiment of the disclosure. The insertion loss S21 indicates a difference between power inputted to the first terminal T1 and power outputted to the second terminal T2. A graph 1722 illustrates an insertion loss S43 of the flexible printed circuit board 5 according to the embodiment of the disclosure. The insertion loss S43 indicates a difference between power inputted to the fourth terminal T4 and power outputted to the third terminal T3.

A graph 1821 illustrates an insertion loss S21 of the flexible printed circuit board 1601 according to the first comparative example. A graph 1822 illustrates an insertion loss S43 of the flexible printed circuit board 1601 according to the first comparative example.

Table 2 shows insertion losses of the flexible printed circuit board 5 according to the embodiment of the disclosure and insertion losses of the flexible printed circuit board 1601 according to the first comparative example when the first signal with the first frequency (e.g., about 3.5 GHz) is transmitted through the first signal line S1 and the second signal with the second frequency (e.g., about 2.35 GHz) is transmitted through the second signal line S2.

**[Table 2]**

| | Flexible printed circuit board 5 according to embodiment of the disclosure | | Flexible printed circuit board 1601 according to first comparative example | | Amount of deterioration | |
|---|---|---|---|---|---|---|
| Insert Loss | 2.35 GHz | 3.5 GHz | 2.35 GHz | 3.5 GHz | 2.35 GHz | 3.5 GHz |
| S21 | | -1.64 | | -0.97 | | 0.67 |
| S43 | -3.54 | | -1.03 | | 2.51 | |

With reference to Table 2, the insertion losses of the flexible printed circuit board 5 according to the embodiment of the disclosure may be larger than the insertion losses of the flexible printed circuit board 1601 according to the first comparative example because of the addition of the first filter F1 and the second filter F2 but may be at a level for ensuring transmission performance and/or signal integrity.

According to the embodiment, one of the first signal line S1 and the second signal line S2 may be configured to transmit the transmission signal (e.g., the Rx signal), and the other of the first signal line S1 and the second signal line S2 may be configured to transmit the reception signal (e.g., the Tx signal). The transmission signal and the reception signal may be respectively included in different frequency bands. Because intensity of the transmission signal may be higher than intensity of the reception signal, one signal line for transmitting the transmission signal under the electromagnetic interference between the first signal line S1 and the second signal line S2 may be defined or interpreted as an 'aggressor line', and the other signal line for transmitting the reception signal may be defined or interpreted as a 'victim line'.

According to the embodiment, the second terminal T2 may be used as the first input terminal (or the first input end) configured to input the first signal (e.g., the transmission signal) in the first frequency band, and the first terminal T1 may be used as the first output terminal (or the first output end) configured to output the first signal. The third terminal T3 may be used as the second input terminal (or the second input end) configured to input the second signal (e.g., the reception signal) in the second frequency band, and the fourth terminal T4 may be used as the second output terminal (or the second output end) configured to output the second signal. The first filter F1 (e.g., the first notch filter) may have the frequency response that allows the first signal in the first frequency band to pass through the first filter, reduces a degree to which the second signal in an undesired (or unnecessary) second frequency band passes through the first filter, and/or substantially prevents the second signal in an undesired (or unnecessary) second frequency band from passing through the first filter. The first filter F1 may be disposed on the first part 51 including the first output terminal (e.g., the first terminal T1). The second filter F2 (e.g., second notch filter) may have the frequency response that allows the second signal in the second frequency band to pass through the second filter, reduces a degree to which the first signal in an undesired (or unnecessary) first frequency band passes through the second filter, and/or substantially prevents the first signal in an undesired (or unnecessary) first frequency band from passing through the second filter. The second filter F2 may be disposed on the second part 52 including the second output terminal (e.g., the fourth terminal T4). In the flexible printed circuit board 5 according to the embodiment of the disclosure, the first filter F1 is disposed on the first part 51 including the first output terminal (e.g., the first terminal T1), and the second filter F2 is disposed on the second part 52 including the second output terminal (e.g., the fourth terminal T4). Therefore, the flexible printed circuit board 5 according to the embodiment of the disclosure may not substantially generate the electromagnetic coupling between the first filter F1 and the second filter F2 and the deterioration in isolation caused by the electromagnetic coupling in comparison with the flexible printed circuit board 1602 according to the second comparative example and the printed circuit board (not illustrated separately) according to the third comparative example.

According to various embodiments, the first terminal T1 may be used as the first input terminal (or the first input end) configured to input the first signal (e.g., the transmission signal) in the first frequency band, and the second terminal T2 may be the second output terminal (or the second output end) configured to output the first signal. The fourth terminal T4 may be used as the second input terminal (or the second input end) configured to input the second signal (e.g., the reception signal) in the second frequency band, and the third terminal T3 may be used as the second output terminal (or the second output end) configured to output the second signal. The first filter F1 (e.g., the first notch filter) may have the frequency response that allows the first signal in the first frequency band to pass through the first filter, reduces a degree to which the second signal in an undesired (or unnecessary) second frequency band passes through the first filter, and/or substantially prevents the second signal in an undesired (or unnecessary) second frequency band from passing through the first filter. The first filter F1 may be disposed on the first part 51 including the first input terminal (e.g., the first terminal T1). The second filter F2 (e.g., second notch filter) may have the frequency response that allows the second signal in the second frequency band to pass through the second filter, reduces a degree to which the first signal in an undesired (or unnecessary) first frequency band passes through the second filter, and/or substantially prevents the first signal in an undesired (or unnecessary) first frequency band from passing through the second filter. The second filter F2 may be disposed on the second part 52 including the second input terminal (e.g., the fourth terminal T4). In the flexible printed circuit board 5 according to the embodiment of the disclosure, the first filter F1 is disposed on the first part 51 including the first input terminal (e.g., the first terminal T1), and the second filter F2 is disposed on the second part 52 including the second input terminal (e.g., the fourth terminal T4). Therefore, the flexible printed circuit board 5 according to the embodiment of the disclosure may not substantially generate the electromagnetic coupling between the first filter F1 and the second filter F2 and the deterioration in isolation caused by the electromagnetic coupling in comparison with the flexible printed circuit board 1602 according to the second comparative example and the printed circuit board (not illustrated separately) according to the third comparative example.

According to the exemplary embodiment of the disclosure, the electronic device 2 includes a first electrical element (e.g., the first printed circuit board 441), a second electrical element (e.g., the second printed circuit board 451), and the flexible printed circuit board 5. The flexible printed circuit board 5 transmits signals between the first electrical element and the second electrical element. The flexible circuit board 5 includes the first part 51, the second part 52, and the third part 53. The third part 53 is positioned between the first part 51 and the second part 52. The flexible circuit board 5 includes the first signal line S1, the second signal line S2, the first filter F1, and the second filter F2. The first signal line S1 and the second signal line S2 extend from the first part 51 to the second part 52. The first filter F1 is included in the first part 51 and includes the first conductive pattern 8 electrically connected to the first signal line S 1. The second filter F2 is included in the second part 52 and includes the second conductive pattern 1000 electrically connected to the second signal line S2. The first filter F1 and the second filter F2 are configured to have the designated electromagnetic isolation between the first signal line S1 and the second signal line S2.

According to the exemplary embodiment of the disclosure, the first signal in the first frequency band may be transmitted through the first signal line S1. The second signal in the second frequency band different from the first frequency band may be transmitted through the second signal line S2. The first filter F1 may include the first notch filter configured to block the second signal. The second filter F2 may include the second notch filter configured to block the second signal.

According to the exemplary embodiment of the disclosure, the first part 51 and the second part 52 of the flexible printed circuit board 5 may be rigid. The third part 53 of the flexible printed circuit board 5 may be flexible.

According to the exemplary embodiment of the disclosure, the electronic device 2 may further include the first connector 541 and the second connector 542. The first connector 541 may be disposed on the first part 51 and electrically connected to the first signal line S1 and the second signal line S2. The first connector 541 may be electrically connected to the first electrical element (e.g., the first printed circuit board 441). The second connector 542 may be disposed on the second part 52 and electrically connected to the first signal line S1 and the second signal line S2. The second connector 542 may be electrically connected to the second electrical element (e.g., the second printed circuit board 441).

According to the exemplary embodiment of the disclosure, the first conductive pattern 8 may include the first partially conductive pattern 81 and the second partially conductive pattern 82 respectively included in different pattern layers of the flexible printed circuit board 5. The first partially conductive pattern 81 and the second partially conductive pattern 82 may be electrically connected to the first signal line S1 through the conductive via (e.g., the first conductive via V1).

According to the exemplary embodiment of the disclosure, the first partially conductive pattern 81 may include the first plane 812. The second partially conductive pattern 82 may include the second plane 822 that faces the first plane 812. The first conductive pattern 8 may apply the first capacitance C1 between the first signal line S1 and the second signal line S2 through the electromagnetic coupling between the first plane 821 and the second plane 822.

According to the exemplary embodiment of the disclosure, the second partially conductive pattern 82 may include the first trace 821 extending from the second plane 822. The first conductive pattern 8 may apply the first inductance L1 between the first signal line S1 and the second signal line S2 through the first trace 821.

According to the exemplary embodiment of the disclosure, the second conductive pattern 1000 may include the third partially conductive pattern 1010 and the fourth partially conductive pattern 1020 respectively included in different pattern layers of the flexible printed circuit board 5. The third partially conductive pattern 1010 and the fourth partially conductive pattern 1020 may be electrically connected to the second signal line S2 through the conductive via (e.g., the fifth conductive via V5).

According to the exemplary embodiment of the disclosure, the third partially conductive pattern 1010 may include the third plane 1012. The fourth partially conductive pattern 1020 may include the second plane 1022 that faces the third plane 1012. In the electronic device, the second conductive pattern 1000 applies the second capacitance C2 between the first signal line S1 and the second signal line S2 through the electromagnetic coupling between the third plane 1021 and the fourth plane 1022.

According to the exemplary embodiment of the disclosure, the fourth partially conductive pattern 1020 may include the second trace 1021 extending from the fourth plane 1022. The second conductive pattern 1000 may apply the second inductance L2 between the first signal line S1 and the second signal line S2 through the second trace 1021.

According to the exemplary embodiment of the disclosure, the electronic device 2 includes the first electrical element (e.g., the first printed circuit board 441), the second electrical element (e.g., the second printed circuit board 451), and the flexible printed circuit board 5. The flexible printed circuit board 5 transmits signals between the first electrical element and the second electrical element. The flexible circuit board 5 includes the first part 51, the second part 52, and the third part 53. The third part 53 is positioned between the first part 51 and the second part 52. The flexible circuit board 5 includes the first signal line S1, the second signal line S2, the first notch filter (e.g., the first filter F1), and the second notch filter (e.g., the second filter F2). The first signal line S1 and the second signal line S2 extend from the first part 51 to the second part 52. The first notch filter is included in the first part 51 and includes the first conductive pattern 8 electrically connected to the first signal line S1. The second notch filter is included in the second part 52 and includes the second conductive pattern 1000 electrically connected to the second signal line S2. The first signal in the first frequency band is transmitted through the first signal line S1. The second signal in the second frequency band different from the first frequency band is transmitted through the second signal line S2. The first notch filter may be configured to block the second signal. The second notch filter is configured to block the first signal.

According to the exemplary embodiment of the disclosure, the first part 51 and the second part 52 of the flexible printed circuit board 5 may be rigid. The third part 53 of the flexible printed circuit board 5 may be flexible.

According to the exemplary embodiment of the disclosure, the electronic device 2 may include the first connector 541 and the second connector 542. The first connector 541 may be disposed on the first part 51 and electrically connected to the first signal line S1 and the second signal line S2. The first connector 541 may be electrically connected to the first electrical element (e.g., the first printed circuit board 441). The second connector 542 may be disposed on the second part 52 and electrically connected to the first signal line S1 and the second signal line S2. The second connector 542 may be electrically connected to the second electrical element (e.g., the second printed circuit board 451).

According to the exemplary embodiment of the disclosure, the first conductive pattern 8 may include the first partially conductive pattern 81 and the second partially conductive pattern 82 respectively included in different pattern layers of the flexible printed circuit board 5. The first partially conductive pattern 81 and the second partially conductive pattern 82 may be electrically connected to the first signal line S1 through the conductive via (e.g., the first conductive via V1).

According to the exemplary embodiment of the disclosure, the second conductive pattern 1000 may include the third partially conductive pattern 1010 and the fourth partially conductive pattern 1020 respectively included in different pattern layers of the flexible printed circuit board 5. The third partially conductive pattern 1010 and the fourth partially conductive pattern 1020 may be electrically connected to the second signal line S2 through the conductive via (e.g., the fifth conductive via V5).

According to the exemplary embodiment of the disclosure, the flexible printed circuit board 5 may include the rigid first part 51, the rigid second part 52, and the flexible third part 53. The third part 53 is positioned between the first part 51 and the second part 52. The flexible printed circuit board 5 may include the first signal line S1, the second signal line S2, the first connector 541, the second connector 542, the first notch filter (e.g., the first filter F1), and the second notch filter (e.g., the second filter F2). The first signal line S1 and the second signal line S2 may extend from the first part 51 to the second part 52. The first connector 541 may be disposed on the first part 51 and electrically connected to the first signal line S1 and the second signal line S2. The second connector 542 may be disposed on the second part 52 and electrically connected to the first signal line S1 and the second signal line S2. The first notch filter may be included in the first part 51 and include the first conductive pattern 8 electrically connected to the first signal line S1. The second notch filter may be included in the second part 52 and include the second conductive pattern 1000 electrically connected to the second signal line S2.

According to the exemplary embodiment of the disclosure, the first signal line S1 may be configured to transmit the first signal in the first frequency band. The second signal line S2 may be configured to transmit the second signal in the second frequency band different from the first frequency band. The first notch filter (e.g., the first filter F1) may be configured to block the second signal. The second notch filter (e.g., the second filter F2) may be configured to block the first signal.

According to the exemplary embodiment of the disclosure, the first conductive pattern 8 may be electrically connected to the first signal line S1 through the conductive via (e.g., the first conductive via V1). The second conductive pattern 1000 may be electrically connected to the second signal line S2 through the conductive via (e.g., the fifth conductive via V5).

According to the exemplary embodiment of the disclosure, the first conductive pattern 8 may include the first partially conductive pattern 81 and the second partially conductive pattern 82 respectively included in different pattern layers of the flexible printed circuit board 5. The first partially conductive pattern 81 and the second partially conductive pattern 82 may be electrically connected to the first signal line S1 through the conductive via (e.g., the first conductive via V1).

According to the exemplary embodiment of the disclosure, the second conductive pattern 1000 may include the third partially conductive pattern 1010 and the fourth partially conductive pattern 1020 respectively included in different pattern layers of the flexible printed circuit board 5. The third partially conductive pattern 1010 and the fourth partially conductive pattern 1020 may be electrically connected to the second signal line S2 through the conductive via (e.g., the fifth conductive via V5).

The embodiments of the disclosure disclosed in the disclosure and illustrated in the drawings are provided as particular examples for more easily explaining the technical contents according to the disclosure and helping understand the disclosure, but not intended to limit the scope of the disclosure. Accordingly, the scope of the various embodiments of the disclosure should be interpreted as including alterations or modifications in addition to the disclosed embodiments. Additionally, it will be understood that any embodiment(s) described herein may be used in conjunction with any other embodiment(s) described herein. In particular, it is stressed that, although the present disclosure has been presented in a form in which a number of embodiments each defining a number of features are provided, where some of these embodiments are linked only through referring to the same figure or figures, the present disclosure should be understood to include all combinations of these embodiments, unless there is a clear contradiction between two (or more) embodiments. In other words, where features are presented as optional herein, all combinations of such optional features are included in this disclosure.

## Claims

1. A flexible circuit board (5) comprising
a first part (51), a second part (52), and a third part (53) positioned between the first part (51) and the second part (52),
a first signal line (S1) extending from the first part (51) to the second part (52);
a second signal line (S2) extending from the first part (51) to the second part (52);
a first filter (F1) included in the first part (51) and including a first conductive pattern (8) electrically connected to the first signal line (S1); and
a second filter (F2) included in the second part (52) and including a second conductive pattern (1000) electrically connected to the second signal line (S2), and
wherein the first filter (F1) and the second filter (F2) are configured to have designated electromagnetic isolation between the first signal line (S1) and the second signal line (S2).

2. The flexible circuit board of claim 1, wherein a first signal in a first frequency band is transmitted through the first signal line (S1), a second signal in a second frequency band different from the first frequency band is transmitted through the second signal line (S2), the first filter (F1) comprises a first notch filter configured to block the second signal, and the second filter (F2) comprises a second notch filter configured to block the second signal.

3. The flexible circuit board of claim 1 or 2, wherein the first part (51) and the second part (52) of the flexible printed circuit board (5) are rigid, and the third part (53) of the flexible printed circuit board (5) is flexible.

4. The flexible circuit board of any one of claims 1 to 3, further comprising:
a first connector (541) disposed on the first part (51) and electrically connected to the first signal line (S1) and the second signal line (S2); and
a second connector (542) disposed on the second part (52) and electrically connected to the first signal line (S1) and the second signal line (S2),
wherein the first connector (541) is electrically connected to a first electrical element (441) of an electronic device (2), and the second connector (542) is electrically connected to a second electrical element (451) of the electronic device (2).

5. The flexible circuit board of any one of claims 1 to 4, wherein the first conductive pattern (8) comprises a first partially conductive pattern (81) and a second partially conductive pattern (82) respectively included in different pattern layers of the flexible printed circuit board (5), and the first partially conductive pattern (81) and the second partially conductive pattern (82) are electrically connected to the first signal line (S1) through a conductive via (V1).

6. The flexible circuit board of claim 5, wherein the first partially conductive pattern (81) comprises a first plane (812), the second partially conductive pattern (82) comprises a second plane (822) facing the first plane (812), and the first conductive pattern (8) applies first capacitance (C1) between the first signal line (S1) and the second signal line (S2) through electromagnetic coupling between the first plane (821) and the second plane (822).

7. The flexible circuit board of claim 6, wherein the second partially conductive pattern (82) comprises a first trace (821) extending from the second plane (822), and the first conductive pattern (8) applies first inductance (L1) between the first signal line (S1) and the second signal line (S2) through the first trace (821).

8. The flexible circuit board of any one of claims 1 to 7, wherein the second conductive pattern (1000) comprises a third partially conductive pattern (1010) and a fourth partially conductive pattern (1020) respectively included in different pattern layers of the flexible printed circuit board (5), and the third partially conductive pattern (1010) and the fourth partially conductive pattern (1020) are electrically connected to the second signal line (S2) through a conductive via (V5).

9. The flexible circuit board of claim 8, wherein the third partially conductive pattern (1010) comprises a third plane (1012), the fourth partially conductive pattern (1020) comprises a second plane (1022) facing the third plane (1012), and the second conductive pattern (1000) applies second capacitance (C2) between the first signal line (S 1) and the second signal line (S2) through electromagnetic coupling between the third plane (1021) and the fourth plane (1022).

10. The flexible circuit board of claim 9, wherein the fourth partially conductive pattern (1020) comprises a second trace (1021) extending from the fourth plane (1022), and the second conductive pattern (1000) applies second inductance (L2) between the first signal line (S 1) and the second signal line (S2) through the second trace (1021).

11. An electronic device (2) comprising:
a first electrical element (441) and a second electrical element (451); and
a flexible circuit board (5) according to any of claims 1-10, configured to transmit signals between the first electrical element (441) and the second electrical element (451).
